# EUROPEAN PATENT APPLICATION

(11) **EP 4 016 607 A1**
(43) Date of publication of application: **22.06.2022**
(21) Application number: 21198383.8
(22) Date of filing: 22.09.2021
(51) Int. Cl.: H01L 23/36, H01L 23/538

(54) **INTER-COMPONENT MATERIAL IN MICROELECTRONIC ASSEMBLIES HAVING DIRECT BONDING**

(30) Priority: 15.12.2020 US 202017122167
(71) Applicant: INTEL Corporation, Santa Clara, CA 95054 (US)
(72) Inventor: EID, Feras, Chandler, 85226 (US); SWAN, Johanna, Scottsdale, 85255 (US); ELSHERBINI, Adel A., Tempe, 85284 (US); LIFF, Shawna, Scottsdale, 85255 (US); ALEKSOV, Aleksandar, Chandler, 85286 (US)
(74) Representative: 2SPL Patentanwälte PartG mbB

(57) **Abstract**

Disclosed herein are microelectronic assemblies including microelectronic components that are coupled together by direct bonding, and related structures and techniques. In some embodiments, a microelectronic assembly may include an interposer; a first microelectronic component having a first surface coupled to the interposer by a first direct bonding region and an opposing second surface; a second microelectronic component having a first surface coupled to the interposer by a second direct bonding region and an opposing second surface; a liner material on the surface of the interposer and around the first and second microelectronic components; an inorganic fill material on the liner material and between the first and second microelectronic components; and a third microelectronic component coupled to the second surfaces of the first and second microelectronic components. In some embodiments, the liner material, the inorganic fill material, and a material of the third microelectronic component may include a thermally conductive material.

## Description

### Background

An integrated circuit (IC) package typically includes a die wirebonded or soldered to an interposer, an underfill material between the die and the interposer, and a mold material disposed around the die. The mold material is usually temperature sensitive, which limits the types of manufacturing processes that can be used during semiconductor assembly. In use, the mold material can negatively affect processor performance by limiting heat transfer away from hot spots in the IC package.

### Brief Description of the Drawings

Embodiments will be readily understood by the following detailed description in conjunction with the accompanying drawings. To facilitate this description, like reference numerals designate like structural elements. Embodiments are illustrated by way of example, not by way of limitation, in the figures of the accompanying drawings.
FIG. 1 is a side, cross-sectional view of an example microelectronic assembly including direct bonding and an inter-component material, in accordance with various embodiments.
FIG. 2 is a side, cross-sectional exploded view of a portion of the microelectronic assembly of FIG. 1, in accordance with various embodiments.
FIGS. 3A-3G are side, cross-sectional views of example stages in the manufacture of a portion of the microelectronic assembly of FIGS. 1 and 2, in accordance with various embodiments.
FIGS. 4A-4D are side, cross-sectional magnified views of the dotted-line portion of FIG. 3G illustrating example bonding interfaces, in accordance with various embodiments.
FIG. 5 is a side, cross-sectional view of an example microelectronic assembly including direct bonding and an inter-component material, in accordance with various embodiments.
FIGS. 6A-6F are side, cross-sectional views of example stages in the manufacture of the microelectronic assembly of FIG. 3, in accordance with various embodiments.
FIG. 7 is a side, cross-sectional view of an example microelectronic assembly including direct bonding and an inter-component thermal dissipative material, in accordance with various embodiments.
FIG. 8 is a top view of a wafer and dies that may be included in a microelectronic component in accordance with any of the embodiments disclosed herein.
FIG. 9 is a side, cross-sectional view of an integrated circuit (IC) device that may be included in a microelectronic component in accordance with any of the embodiments disclosed herein.
FIG. 10 is a side, cross-sectional view of an IC device assembly that may include a microelectronic assembly in accordance with any of the embodiments disclosed herein.
FIG. 11 is a block diagram of an example electrical device that may include a microelectronic assembly in accordance with any of the embodiments disclosed herein.

### Detailed Description

Disclosed herein are microelectronic assemblies including microelectronic components that are coupled together by direct bonding regions with an inorganic dielectric fill material disposed around the microelectronic components, as well as related structures and techniques. For example, in some embodiments, a microelectronic assembly may include an interposer having a first surface and an opposing second surface; a first microelectronic component coupled to the second surface of the interposer by a first direct bonding region; a second microelectronic component coupled to the second surface of the interposer by a second direct bonding region; a liner material on the second surface of the interposer and around the first and second microelectronic components; and an inorganic dielectric material on the liner material and between the first and second microelectronic components. In some embodiments, a microelectronic assembly may include an interposer having a first surface and an opposing second surface, a first microelectronic component coupled to the second surface of the interposer by a first direct bonding region, a second microelectronic component coupled to the second surface of the interposer by a second direct bonding region, a liner material on the second surface of the interposer and around the first and second microelectronic components, and a thermally conductive fill material on the liner material and between the first and second microelectronic components.

In the following detailed description, reference is made to the accompanying drawings that form a part hereof wherein like numerals designate like parts throughout, and in which is shown, by way of illustration, embodiments that may be practiced. It is to be understood that other embodiments may be utilized, and structural or logical changes may be made, without departing from the scope of the present disclosure. Therefore, the following detailed description is not to be taken in a limiting sense.

Various operations may be described as multiple discrete actions or operations in turn, in a manner that is most helpful in understanding the claimed subject matter. However, the order of description should not be construed as to imply that these operations are necessarily order dependent. In particular, these operations may not be performed in the order of presentation. Operations described may be performed in a different order from the described embodiment. Various additional operations may be performed, and/or described operations may be omitted in additional embodiments.

For the purposes of the present disclosure, the phrases "A and/or B" and "A or B" mean (A), (B), or (A and B). For the purposes of the present disclosure, the phrases "A, B, and/or C" and "A, B, or C" mean (A), (B), (C), (A and B), (A and C), (B and C), or (A, B, and C). The drawings are not necessarily to scale. Although many of the drawings illustrate rectilinear structures with flat walls and right-angle corners, this is simply for ease of illustration, and actual devices made using these techniques will exhibit rounded corners, surface roughness, and other features.

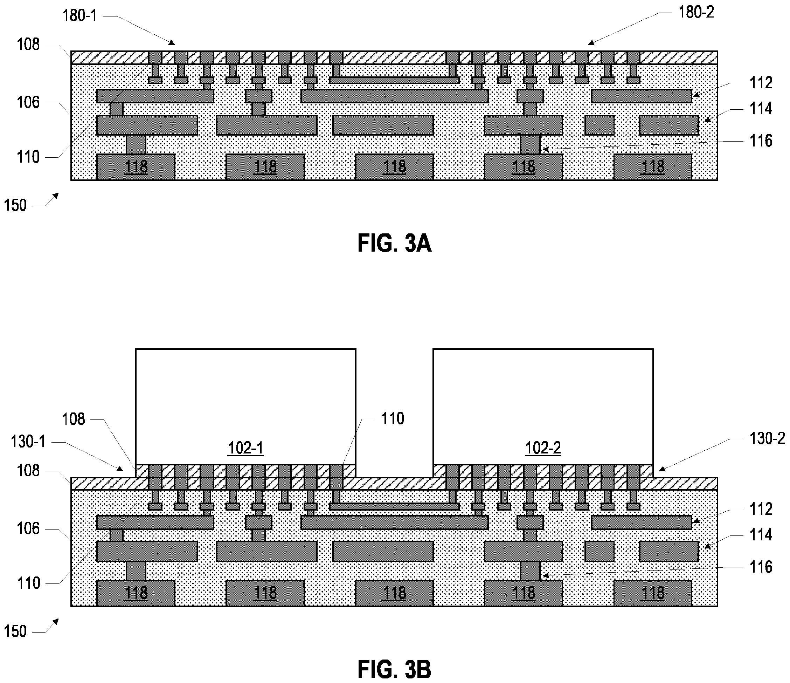

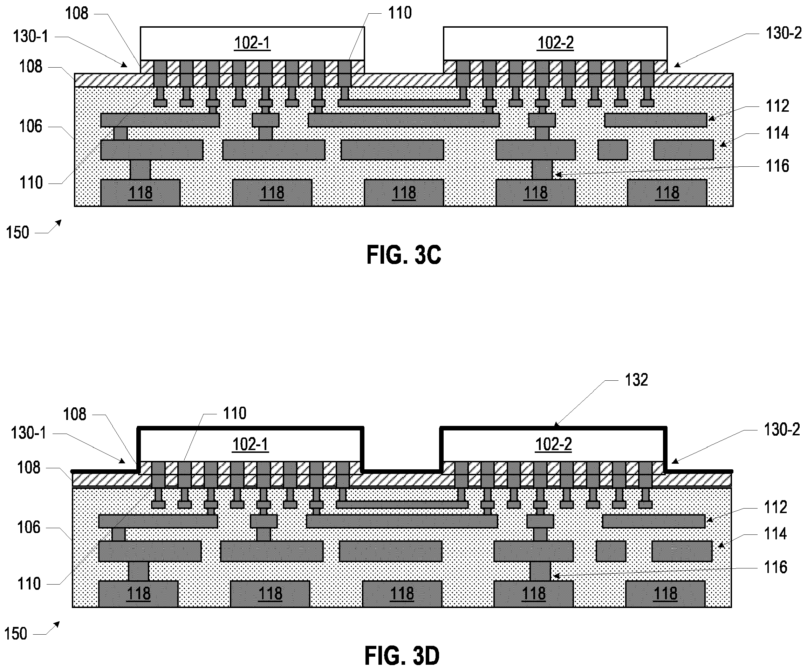

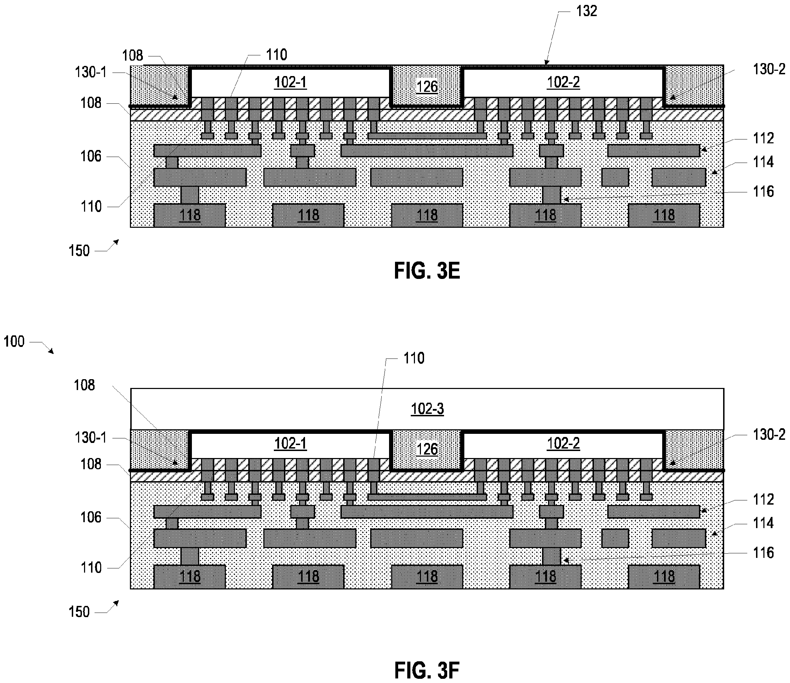

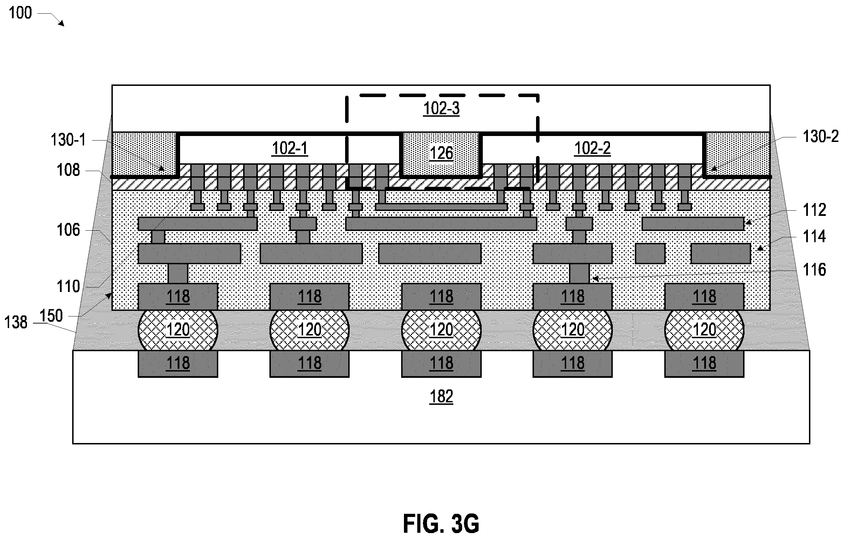

The description uses the phrases "in an embodiment" or "in embodiments," which may each refer to one or more of the same or different embodiments. Furthermore, the terms "comprising," "including," "having," and the like, as used with respect to embodiments of the present disclosure, are synonymous. When used to describe a range of dimensions, the phrase "between X and Y" represents a range that includes X and Y. The terms "top," "bottom," etc. may be used herein to explain various features of the drawings, but these terms are simply for ease of discussion, and do not imply a desired or required orientation. Although certain elements may be referred to in the singular herein, such elements may include multiple sub-elements. For example, "a dielectric material" may include one or more dielectric materials. As used herein, a "conductive contact" may refer to a portion of conductive material (e.g., metal) serving as an electrical interface between different components; conductive contacts may be recessed in, flush with, or extending away from a surface of a component, and may take any suitable form (e.g., a conductive pad or socket, or portion of a conductive line or via). For ease of discussion, the drawings of FIGS. 3A-3G may be referred to herein as "FIG. 3."

Conventional techniques for the heterogeneous integration of dies of varying semiconductor nodes to create a composite die generally include thermal compression bonding or mass reflow of one die or multiple dies to a wafer of a differing node and providing an underfill material and/or a mold material to enable subsequent processing, such as through substrate via (TSV) reveal and controlled collapse chip connection (C4) bumping. The use of low temperature polymer dielectrics as underfill and/or mold material strictly limits the temperature which subsequent processing of the composite die may reach to avoid outgassing, over-softening, or degradation of the dielectrics, which can cause damage to the individual dies and/or to the interconnects between the dies and the wafer. The use of low temperature polymer dielectrics is likely to lead to extreme wafer bow (e.g., bowing of greater than 800 microns), which makes wafer handling extremely challenging during processing. Further, the use of a low temperature polymer dielectric is likely to reduce performance by preventing heat transfer away from a heat source. The microelectronic assemblies and methods disclosed herein provide improved materials and structures that enable the composite dies to be made with inorganic materials that can be exposed to high temperatures and allow better heat dissipation, and that can be handled more easily during processing to allow for a more streamlined manufacturing relative to conventional approaches.

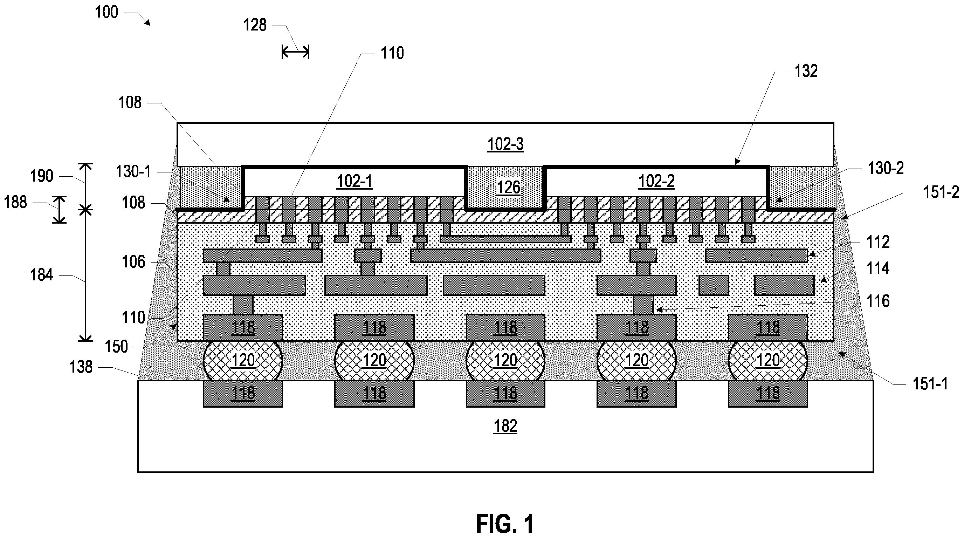

FIG. 1 is a side, cross-sectional view of a microelectronic assembly 100, in accordance with various embodiments. The microelectronic assembly 100 may include an interposer 150, a first microelectronic component 102-1, a second microelectronic component 102-2, a third microelectronic component 102-3, a liner material 132, an inter-component fill material 126, a support component 182, and an underfill material 138. The interposer 150 includes a first surface 151-1 (i.e., a bottom surface) and an opposing second surface 151-2 (i.e., a top surface).

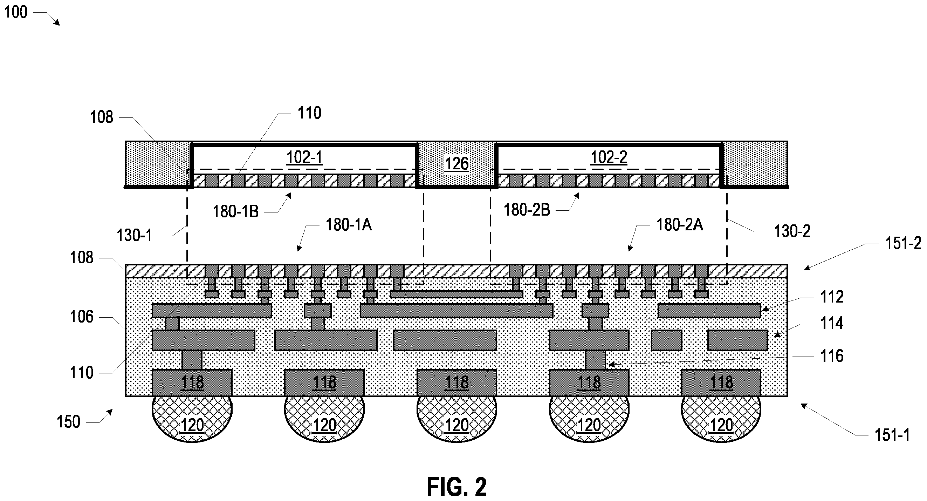

The microelectronic assembly 100 may include an interposer 150 coupled to the microelectronic component 102-1 by a direct bonding (DB) region 130-1 and coupled to the microelectronic component 102-2 by a DB region 130-2. In particular, as illustrated in FIG. 2, the DB region 130-1 may include a DB interface 180-1A at the top surface 151-2 of the interposer 150, with the DB interface 180-1A including a set of conductive DB contacts 110 and a DB dielectric 108 around the DB contacts 110 of the DB interface 180-1A. The DB region 130-1 may also include a DB interface 180-1B at the bottom surface of the microelectronic component 102-1, with the DB interface 180-1B including a set of DB contacts 110 and a DB dielectric 108 around the DB contacts 110 of the DB interface 180-1B. The DB contacts 110 of the DB interface 180-1A of the interposer 150 may align with the DB contacts 110 of the DB interface 180-1B of the microelectronic component 102-1 so that, in the microelectronic assembly 100, the DB contacts 110 of the microelectronic component 102-1 are in contact with the DB contacts 110 of the interposer 150. In the microelectronic assembly 100 of FIG. 1, the DB interface 180-1A of the interposer 150 may be bonded (e.g., electrically and mechanically) with the DB interface 180-1B of the microelectronic component 102-1 to form the DB region 130-1 coupling the interposer 150 and the microelectronic component 102-1 As further shown in FIG. 2, the microelectronic component 102-2 may be coupled to the interposer 150 by a DB region 130-2 (via the DB interfaces 180-2A and 180-2B). More generally, the DB regions 130 disclosed herein may include two complementary DB interfaces 180 bonded together; for ease of illustration, many of the subsequent drawings may omit the identification of the DB interfaces 180 to improve the clarity of the drawings. Although FIGS. 1 and 2 show the first and second microelectronic components as single-sided (in the sense that an individual microelectronic component 102 only has conductive contacts (e.g., DB contacts 110) on a single surface of the individual microelectronic component 102), the microelectronic components 102 may be double-sided (in the sense that an individual microelectronic component 102 may have conductive contacts on multiple surfaces of the individual microelectronic component 102).

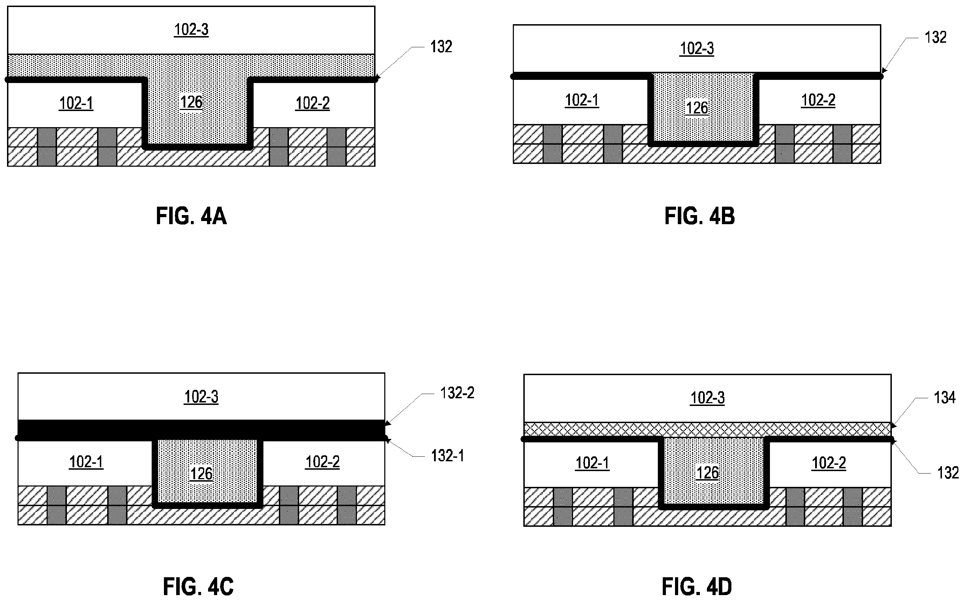

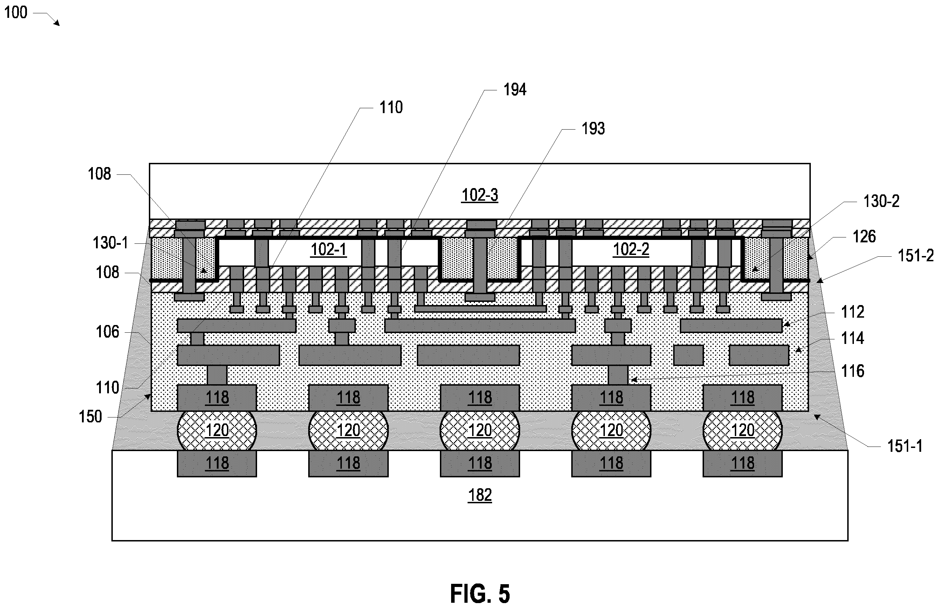

The microelectronic assembly 100 may also include a third microelectronic component 102-3 coupled to the first and second microelectronic components 102-1, 102-2 by fusion bonding regions and/or by direct bonding regions, as described below with reference to FIG. 4. In some embodiments, as shown in FIG. 1, the third microelectronic component 102-3 may not include conductive structures (e.g., may be blank or passive) on a bottom surface, such that the dielectric on the bottom surface of the third microelectronic 102-3 couples to the inter-component fill material 126 and the single-sided first and second microelectronic components 102-1, 102-2 via fusion bonding. In such embodiments, the third microelectronic component 102-3 may further include passive thermal dissipative features or structures to direct and spread heat from the first and second microelectronic components 102-1, 102-2. In some embodiments, as shown in FIG. 5, the third microelectronic component 102-3 may include conductive structures on the bottom surface and/or the top surface (e.g., may be an active wafer or die), such that the conductive contacts and/or dielectric material on the bottom surface of the third microelectronic component 102-3 couple to the conductive contacts on the top surface of the double-sided first and second microelectronic components 102-1, 102-2 via direct bonding.

As used herein, the term "direct bonding" is used to include metal-to-metal bonding techniques (e.g., copper-to-copper bonding, or other techniques in which the DB contacts 110 of opposing DB interfaces 180 are brought into contact first, then subject to heat and/or compression) and hybrid bonding techniques (e.g., techniques in which the DB dielectric 108 of opposing DB interfaces 180 are brought into contact first, then subject to heat and sometimes compression, or techniques in which the DB contacts 110 and the DB dielectric 108 of opposing DB interfaces 180 are brought into contact substantially simultaneously, then subject to heat and compression). In such techniques, the DB contacts 110 and the DB dielectric 108 at one DB interface 180 are brought into contact with the DB contacts 110 and the DB dielectric 108 at another DB interface 180, respectively, and elevated pressures and/or temperatures may be applied to cause the contacting DB contacts 110 and/or the contacting DB dielectrics 108 to bond. In some embodiments, this bond may be achieved without the use of intervening solder or an anisotropic conductive material, while in some other embodiments, a thin cap of solder may be used in a DB interconnect to accommodate planarity, and this solder may become an intermetallic compound (IMC) in the DB region 130 during processing. DB interconnects may be capable of reliably conducting a higher current than other types of interconnects; for example, some conventional solder interconnects may form large volumes of brittle IMCs when currentflows, and the maximum current provided through such interconnects may be constrained to mitigate mechanical failure. As used herein, the term "fusion bonding" refers to dielectric-to-dielectric bonding techniques (e.g., techniques in which the dielectric of opposing interfaces are brought into contact, then subject to heat and sometimes compression).

A DB dielectric 108 may include one or more dielectric materials, such as one or more inorganic dielectric materials. For example, a DB dielectric 108 may include silicon and nitrogen (e.g., in the form of silicon nitride); silicon and oxygen (e.g., in the form of silicon oxide); silicon, carbon, and nitrogen (e.g., in the form of silicon carbonitride); carbon and oxygen (e.g., in the form of a carbon-doped oxide); silicon, oxygen, and nitrogen (e.g., in the form of silicon oxynitride); aluminum and oxygen (e.g., in the form of aluminum oxide); titanium and oxygen (e.g., in the form of titanium oxide); hafnium and oxygen (e.g., in the form of hafnium oxide); silicon, oxygen, carbon, and hydrogen (e.g., in the form of tetraethyl orthosilicate (TEOS)); zirconium and oxygen (e.g., in the form of zirconium oxide); niobium and oxygen (e.g., in the form of niobium oxide); or tantalum and oxygen (e.g., in the form of tantalum oxide); and combinations thereof. In some embodiments, the DB dielectric 108 is a same material as a material of the interposer 150 and the microelectronic component 102, such that the DB dielectric 108 is an integrated part of the respective interposer 150 or the respective microelectronic component 102 (e.g., the DB dielectric 108 may or may not be deposited as a separate material layer). In some embodiments, the DB dielectric 108 is a different material then a material of the interposer 150 and/or the microelectronic component 102, such that the DB dielectric 108 is deposited as a separate material layer on the respective interposer 150 and/or the respective microelectronic component 102.

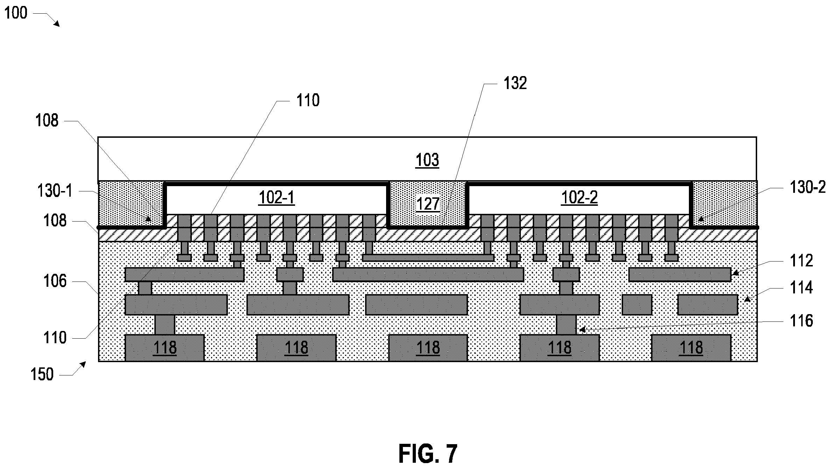

The microelectronic assembly 100 of FIG. 1 may also include an inter-component fill material 126. The inter-component fill material 126 may extend between (e.g., around) one or more of the microelectronic components 102 on the interposer 150. In some embodiments, the inter-component fill material 126 may extend between multiple microelectronic components 102 on the interposer 150 and around the DB regions 130. In some embodiments, the inter-component fill material 126 may extend above one or more of the microelectronic components 102 on an interposer 150 (not shown). The inter-component fill material 126 may be an inorganic dielectric material, such as silicon and nitrogen (e.g., in the form of silicon nitride) or silicon and oxygen (e.g., in the form of silicon oxide), and a combination thereof. The inter-component fill material 126 may be deposited using any suitable technique, for example, chemical vapor deposition (CVD), atomic layer deposition (ALD), plasma-enhanced chemical vapor deposition (PECVD), spin coating, or vacuum lamination. The inter-component fill material 126 may have a thickness between 10 microns and 250 microns. The inter-component fill material 126 may include a single layer or may include multiple layers. The deposition process may be tuned to optimize mechanical and electrical properties (e.g., porosity and shrinkage) of the inter-component fill material 126. In some embodiments, the inter-component fill material 126 may extend up to and may laterally surround the microelectronic components 102, and in some embodiments (not shown), the inter-component fill material 126 may cover the top surfaces of the microelectronic components 102. As used herein, the terms "inter-component fill material," inter-component material," "inter-die material," "gap material," "fill material," and "dielectric material ... around a microelectronic component" may be used interchangeably. In some embodiments, the inter-component fill material 126 used in a microelectronic assembly 100 may be selected at least in part for its thermal properties to facilitate heat transfer (e.g., as described below with reference to FIG. 7).

The microelectronic assembly 100 of FIG. 1 may also include a liner material 132. The liner material 132 may be disposed on the DB dielectric 108 of the interposer 150 and on and around the first and second microelectronic components 102-1, 102-2. The liner material 132 may serve as an etch stop or a hermetic barrier for an active surface of the interposer 150 (e.g., conductive contacts (not shown) and dielectric on the second surface 151-2 of the interposer 150) and all facets (e.g., side surfaces and top surfaces) of the microelectronic components 102-1, 102-2 to limit diffusion of conductive contacts and the adjacent dielectric (e.g., the copper diffusion that may occur when the DB contacts 110 include copper and the DB dielectric 108 includes silicon oxide). In some embodiments, the liner material 132 may include silicon, carbon, and nitrogen (e.g., in the form of silicon carbon nitride), silicon and nitrogen (e.g., in the form of silicon nitride), silicon, oxygen, and nitrogen (e.g., in the form of silicon oxynitride), or silicon and carbon (e.g., in the form of silicon carbide), and combinations thereof. The liner material 132 may be deposited using any suitable technique, for example, CVD, ALD, or PECVD. During deposition, the temperature, pressure, and power of the process may be adjusted to tune the stress of the film and subsequent stress on the interposer 150 and the first and second microelectronic components 102-1, 102-2. The liner material 132 may have a thickness between 10 nanometers and 2000 nanometers. In some embodiments, the thickness of the liner material 132 may vary (e.g., the liner material 132 may be thicker on the top surfaces of the interposer 150 and the microelectronic components 102 and thinner on the sidewalls of the microelectronic components 102).

The interposer 150 may be referred to as a "bottom die" or a "base wafer." The interposer 150 may include an insulating material 106 (e.g., one or more dielectric materials formed in multiple layers, as known in the art) and one or more conductive pathways 112 through the insulating material 106 (e.g., including conductive lines 114 and/or conductive vias 116, as shown). In some embodiments, the insulating material 106 of the interposer 150 includes an inorganic dielectric material, such as silicon and nitrogen (e.g., in the form of silicon nitride); silicon and oxygen (e.g., in the form of silicon oxide); silicon and carbon (e.g., in the form of silicon carbide); silicon, carbon, and oxygen (e.g., in the form of silicon oxycarbide); silicon, carbon, and nitrogen (e.g., in the form of silicon carbonitride); carbon and oxygen (e.g., in the form of a carbon-doped oxide); silicon, oxygen, and nitrogen (e.g., in the form of silicon oxynitride); or silicon, oxygen, carbon, and hydrogen (e.g., in the form of tetraethyl orthosilicate (TEOS)); and combinations thereof. In some embodiments, the insulating material 106 of the interposer 150 includes an insulating metal oxide, such as aluminum and oxygen (e.g., in the form of aluminum oxide); titanium and oxygen (e.g., in the form of titanium oxide); hafnium and oxygen (e.g., in the form of hafnium oxide); zirconium and oxygen (e.g., in the form of zirconium oxide); niobium and oxygen (e.g., in the form of niobium oxide); or tantalum and oxygen (e.g., in the form of tantalum oxide); and combinations thereof. In some embodiments, the interposer 150 may be semiconductor-based (e.g., silicon-based) or glass-based. In some embodiments, the interposer 150 is a silicon wafer or die. In some embodiments, the interposer 150 may be a silicon-on-insulator (SOI) and may further include layers of silicon and germanium (e.g., in the form of silicon germanium), gallium and nitrogen (e.g., in the form of gallium nitride), indium and phosphorous (e.g., in the form of indium phosphide), among others.

In some embodiments, the insulating material 106 of the interposer 150 may be an organic material, such as polyimide or polybenzoxazole, or may include an organic polymer matrix (e.g., epoxide) with a filler material (which may be inorganic, such as silicon nitride, silicon oxide, or aluminum oxide). In some such embodiments, the interposer 150 may be referred to as an "organic interposer." In some embodiments, the insulating material 106 of an interposer 150 may be provided in multiple layers of organic buildup film. Organic interposers 150 may be less expensive to manufacture than semiconductor- or glass-based interposers, and may have electrical performance advantages due to the low dielectric constants of organic insulating materials 106 and the thicker lines that may be used (allowing for improved power delivery, signaling, and potential thermal benefits). Organic interposers 150 may also have larger footprints than can be achieved for semiconductor-based interposers, which are limited by the size of the reticle used for patterning. Further, organic interposers 150 may be subject to less restrictive design rules than those that constrain semiconductor- or glass-based interposers, allowing for the use of design features such as non-Manhattan routing (e.g., not being restricted to using one layer for horizontal interconnects and another layer for vertical interconnects) and the avoidance of through-substrate vias (TSVs) such as through-silicon vias or through-glass vias (which may be limited in the achievable pitch, and may result in less desirable power delivery and signaling performance). Conventional integrated circuit packages including an organic interposer have been limited to solder-based attach technologies, which may have a lower limit on the achievable pitch that precludes the use of conventional solder-based interconnects to achieve the fine pitches desired for next generation devices. Utilizing an organic interposer 150 in a microelectronic assembly 100 with direct bonding, as disclosed herein, may leverage these advantages of organic interposers in combination with the ultra-fine pitch (e.g., the pitch 128 discussed below) achievable by direct bonding (and previously only achievable when using semiconductor-based interposers), and thus may support the design and fabrication of large and sophisticated die complexes that can achieve packaged system competition performance and capabilities not enabled by conventional approaches.

In other embodiments, the insulating material 106 of the interposer 150 may include a fire retardant grade 4 material (FR-4), bismaleimide triazine (BT) resin, or low-k or ultra low-k dielectric (e.g., carbon-doped dielectrics, fluorine-doped dielectrics, and porous dielectrics). When the interposer 150 is formed using standard printed circuit board (PCB) processes, the insulating material 106 may include FR-4, and the conductive pathways 112 in the interposer 150 may be formed by patterned sheets of copper separated by buildup layers of the FR-4. In some such embodiments, the interposer 150 may be referred to as a "package substrate" or a "circuit board."

In some embodiments, one or more of the conductive pathways 112 in the interposer 150 may extend between a conductive contact at the top surface of the interposer 150 (e.g., one of the DB contacts 110) and a conductive contact 118 at the bottom surface of the interposer 150. In some embodiments, one or more of the conductive pathways 112 in the interposer 150 may extend between different conductive contacts at the top surface of the interposer 150 (e.g., between different DB contacts 110 potentially in different DB regions 130, as discussed further below). In some embodiments, one or more of the conductive pathways 112 in the interposer 150 may extend between different conductive contacts 118 at the bottom surface of the interposer 150.

In some embodiments, an interposer 150 may only include conductive pathways 112, and may not contain active or passive circuitry. In other embodiments, an interposer 150 may include active or passive circuitry (e.g., transistors, diodes, resistors, inductors, and capacitors, among others). In some embodiments, an interposer 150 may include one or more device layers including transistors.

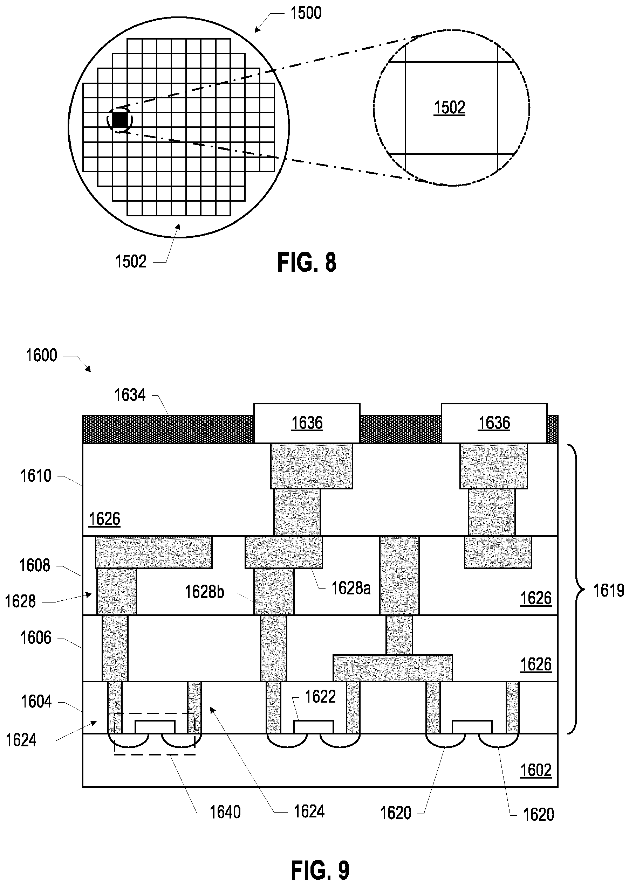

In some embodiments, a microelectronic component 102 may include an IC die (packaged or unpackaged) or a stack of IC dies (e.g., a high-bandwidth memory dies stack). In some such embodiments, the insulating material of a microelectronic component 102 may include silicon dioxide, silicon nitride, oxynitride, polyimide materials, glass-reinforced epoxy matrix materials, or a low-k or ultra low-k dielectric (e.g., carbon-doped dielectrics, fluorine-doped dielectrics, porous dielectrics, organic polymeric dielectrics, photo-imageable dielectrics, and/or benzocyclobutene-based polymers). In some further embodiments, the insulating material of a microelectronic component 102 may include a semiconductor material, such as silicon, germanium, or a III-V material (e.g., gallium nitride), and one or more additional materials. For example, an insulating material of a microelectronic component 102 may include silicon oxide or silicon nitride. The conductive pathways in a microelectronic component 102 may include conductive lines and/or conductive vias, and may connect any of the conductive contacts in the microelectronic component 102 in any suitable manner (e.g., connecting multiple conductive contacts on a same surface or on different surfaces of the microelectronic component 102). Example structures that may be included in the microelectronic components 102 disclosed herein are discussed below with reference to FIG. 9. In particular, a microelectronic component 102 may include active and/or passive circuitry (e.g., transistors, diodes, resistors, inductors, and capacitors, among others). In some embodiments, a microelectronic component 102 may include one or more device layers including transistors. When a microelectronic component 102 includes active circuitry, power and/or ground signals may be routed through the interposer 150 and to/from a microelectronic component 102 through a DB region 130 (and further through intervening microelectronic components 102). In some embodiments, a microelectronic component 102 may take the form of any of the embodiments of the interposer 150 herein. Although the microelectronic components 102 of the microelectronic assembly 100 of FIG. 1 are single-sided components, in some embodiments, a microelectronic component 102 may be a double-sided (or "multi-level," or "omni-directional") component with conductive contacts on multiple surfaces of the component. A particular example of double-sided microelectronic components 102 are discussed below with reference to FIG. 5.

A DB contact 110 may include a pillar, a pad, or other structure. The DB contacts 110, although depicted in the accompanying drawings in the same manner at both DB interfaces 180 of a DB region 130, may have a same structure at both DB interfaces 180, or the DB contacts 110 at different DB interfaces 180 may have different structures. For example, in some embodiments, a DB contact 110 in one DB interface 180 may include a metal pillar (e.g., a copper pillar), and a complementary DB contact 110 in a complementary DB interface 180 may include a metal pad (e.g., a copper pad) recessed in a dielectric. A DB contact 110 may include any one or more conductive materials, such as copper, manganese, titanium, gold, silver, palladium, nickel, copper and aluminum (e.g., in the form of a copper aluminum alloy), tantalum (e.g., tantalum metal, or tantalum and nitrogen in the form of tantalum nitride), cobalt, cobalt and iron (e.g., in the form of a cobalt iron alloy), or any alloys of any of the foregoing (e.g., copper, manganese, and nickel in the form of manganin). Some particular arrangements of multiple materials in a DB contact 110 are discussed below with reference to FIG. 3). In some embodiments, the DB dielectric 108 and the DB contacts 110 of a DB interface 180 may be manufactured using low-temperature deposition techniques (e.g., techniques in which deposition occurs at temperatures below 250 degrees Celsius, or below 200 degrees Celsius), such as low-temperature plasma-enhanced chemical vapor deposition (PECVD).

Although FIG. 1 depicts a particular number of microelectronic components 102 coupled to the interposer 150 by DB regions 130, this number and arrangement are simply illustrative, and a microelectronic assembly 100 may include any desired number and arrangement of microelectronic components 102 coupled to an interposer 150 by DB regions 130. Although a single reference numeral "108" is used to refer to the DB dielectrics of multiple different DB interfaces 180 (and different DB regions 130), this is simply for ease of illustration, and the DB dielectric 108 of different DB interfaces 180 (even within a single DB region 130) may have different materials and/or structures. Similarly, although a single reference numeral "110" is used to refer to the DB contacts of multiple different DB interfaces 180 (and different DB regions 130), this is simply for ease of illustration, and the DB contacts 110 of different DB interfaces 180 (even within a single DB region 130) may have different materials and/or structures. In FIGS. 1 and 2, the DB contacts 110 are shown as pads in contact with vias 116 in the underlying insulating material 106. In other embodiments, the DB contacts 110 may be vias themselves. For example, in an embodiment in which the DB contacts 110 are vias in contact with pads in the insulating material 106, the DB contacts 110 may be narrower than the pads with which they are in contact.

Different DB regions 130 in a microelectronic assembly 100 may include different DB dielectrics 108. For example, a microelectronic assembly 100 in which a DB region 130-1 includes a DB dielectric 108-1 and a DB region 130-2 includes a different DB dielectric 108-2. The DB dielectrics 108-1 and 108-2 may differ in their material composition and/or their structure. In some embodiments, DB dielectrics 108 in different DB regions 130 may be selected to have different thermal conductivities so as to facilitate and/or limit heat transfer between the interposer 150 and the microelectronic components 102. For example, the DB dielectric 108-1 may have a higher thermal conductivity than the DB dielectric 108-2, resulting in greater heat transfer between the microelectronic component 102-1 and the interposer 150 than between the microelectronic component 102-2 and the interposer 150. In some such embodiments, the DB dielectric 108-1 may include silicon and nitrogen (e.g., in the form of silicon nitride) and the DB dielectric 108-2 may include silicon and oxygen (e.g., in the form of silicon oxide); silicon nitride may have a higher thermal conductivity than silicon oxide, and thus the use of silicon nitride as the DB dielectric 108-1 may enhance local heat transfer from the microelectronic component 102-1 to the interposer 150, while the use of silicon oxide as the DB dielectric 108-2 may mitigate thermal cross-talk through the interposer 150 between the microelectronic component 102-1 and the microelectronic component 102-2. In the embodiment of FIGS. 1 and 2, the DB dielectric 108 extends outside of the DB regions 130, covering the remainder of the top surface of the interposer 150. In other embodiments, a different material may be disposed at the top surface of the interposer 150 outside of the DB regions 130 (e.g., in contact with the inter-component fill material 126).

In some embodiments, the density of the DB contacts 110 (i.e., the proportion of the area of a bonding surface of a DB interface 180 occupied by DB contacts 110) may differ between different DB regions 130. In some embodiments, this differing density may be due to one DB region 130 requiring fewer electrical pathways than another DB region 130. In other embodiments, this differing density may be used to enhance or suppress heat transfer, with greater density of DB contacts 110 (and therefore a higher proportion of thermally conductive metal) being used to enhance heat transfer and lesser density of DB contacts 110 (and therefore a lower portion of thermally conductive metal) being used to suppress heat transfer. For example, the density of DB contacts 110 may be greater in the DB region 130-1 than in the DB region 130-2 to enhance heat transfer between the microelectronic component 102-1 and the interposer 150 and to reduce heat transfer between the microelectronic component 102-2 and the interposer 150. In some embodiments, two DB regions 130 may have different densities of DB contacts 110 while having DB dielectrics 108 with the same material composition.

Additional components (not shown), such as surface-mount resistors, capacitors, and/or inductors, may be disposed on the top surface or the bottom surface of the interposer 150, or embedded in the interposer 150. The microelectronic assembly 100 of FIG. 1 also includes a support component 182 coupled to the interposer 150. In the particular embodiment of FIG. 1, the support component 182 includes conductive contacts 118 that are electrically coupled to complementary conductive contacts 118 of the interposer 150 by intervening solder 120 (e.g., solder balls in a ball grid array (BGA) arrangement), but any suitable interconnect structures may be used (e.g., pins in a pin grid array arrangement, lands in a land grid array arrangement, pillars, pads and pillars, etc.). The solder 120 utilized in the microelectronic assemblies 100 disclosed herein may include any suitable materials, such as lead/tin, tin/bismuth, eutectic tin/silver, ternary tin/silver/copper, eutectic tin/copper, tin/nickel/copper, tin/bismuth/copper, tin/indium/copper, tin/zinc/indium/bismuth, or other alloys. In some embodiments, the couplings between the interposer 150 and the support component 182 may be referred to as second-level interconnects (SLI) or multi-level interconnects (MLI).

In some embodiments, the support component 182 may be a package substrate (e.g., may be manufactured using PCB processes, as discussed above). In some embodiments, the support component 182 may be a circuit board (e.g., a motherboard), and may have other components attached to it (not shown). The support component 182 may include conductive pathways and other conductive contacts (not shown) for routing power, ground, and signals through the support component 182, as known in the art. In some embodiments, the support component 182 may include another IC package, an interposer, or any other suitable component. An underfill material 138 may be disposed around the solder 120, the interposer 150, the inter-component fill material 126, and at least a portion of the microelectronic component 102-3 coupling the interposer 150 including the microelectronic components 102 to the support component 182. In some embodiments, the underfill material 138 may include an epoxy material.

In some embodiments, the support component 182 may be a lower density component, while the interposer 150 and/or the microelectronic components 102 may be higher density components. As used herein, the term "lower density" and "higher density" are relative terms indicating that the conductive pathways (e.g., including conductive lines and conductive vias) in a lower density component are larger and/or have a greater pitch than the conductive pathways in a higher density component. In some embodiments, a microelectronic component 102 may be a higher density component, and an interposer 150 may be a lower density component. In some embodiments, a higher density component may be manufactured using a dual damascene or single damascene process (e.g., when the higher density component is a die), while a lower density component may be manufactured using a semi-additive or modified semi-additive process (with small vertical interconnect features formed by advanced laser or lithography processes) (e.g., when the lower density component is a package substrate or an interposer). In some other embodiments, a higher density component may be manufactured using a semi-additive or modified semi-additive process (e.g., when the higher density component is a package substrate or an interposer), while a lower density component may be manufactured using a semi-additive or a subtractive process (using etch chemistry to remove areas of unwanted metal, and with coarse vertical interconnect features formed by a standard laser process) (e.g., when the lower density component is a PCB).

The microelectronic assembly 100 of FIG. 1 may also include a thermal interface material (TIM) (not shown). The TIM may include a thermally conductive material (e.g., metal particles) in a polymer or other binder. The TIM may be a thermal interface material paste or a thermally conductive epoxy (which may be fluid-like or viscous when applied and may harden upon curing, as known in the art). The TIM may also contain a solder material (e.g. indium). The TIM may provide a path for heat generated by the microelectronic components 102 to readily flow to the heat transfer structure, where it may be spread and/or dissipated.

The microelectronic assembly 100 of FIG. 1 may also include a heat transfer structure (not shown). The heat transfer structure may be used to move heat away from one or more of the microelectronic components 102 (e.g., so that the heat may be more readily dissipated). The heat transfer structure may include any suitable thermally conductive material (e.g., metal, appropriate ceramics, etc.), and may include any suitable features (e.g., a heat spreader, a heat sink including fins, a cold plate, etc.). In some embodiments, a heat transfer structure may be or may include an integrated heat spreader (IHS).

The elements of a microelectronic assembly 100 may have any suitable dimensions. Only a subset of the accompanying drawings are labeled with reference numerals representing dimensions, but this is simply for clarity of illustration, and any of the microelectronic assemblies 100 disclosed herein may have components having the dimensions discussed herein. In some embodiments, the thickness 184 of the interposer 150 may be between 20 microns and 200 microns. In some embodiments, the thickness 188 of a DB region 130 may be between 50 nanometers and 5 microns. In some embodiments, a thickness 190 of a microelectronic component 102 may be between 5 microns and 800 microns. In some embodiments, a thickness 190 of a microelectronic component 102 may be between 5 microns and 250 microns. In some embodiments, a thickness 190 of a microelectronic component 102 may be less than 40 microns (e.g., between 5 microns and 40 microns). In some embodiments, a pitch 128 of the DB contacts 110 in a DB region 130 may be less than 20 microns (e.g., between 0.1 microns and 20 microns).

A number of elements are illustrated in FIG. 1 as included in the microelectronic assembly 100, but a number of these elements may not be present in a microelectronic assembly 100. For example, in various embodiments, the microelectronic component 102-3, the underfill material 138, and/or the support component 182 may not be included. Further, FIG. 1 illustrates a number of elements that are omitted from subsequent drawings for ease of illustration, but may be included in any of the microelectronic assemblies 100 disclosed herein. Examples of such elements include the underfill material 138 and/or the support component 182. Many of the elements of the microelectronic assembly 100 of FIG. 1 are included in other ones of the accompanying drawings; the discussion of these elements is not repeated when discussing these drawings, and any of these elements may take any of the forms disclosed herein. In some embodiments, individual ones of the microelectronic assemblies 100 disclosed herein may serve as a system-in-package (SiP) in which multiple microelectronic components 102 having different functionality are included. In such embodiments, the microelectronic assembly 100 may be referred to as an SiP. Although FIGS. 1 and 2 (and others of the accompanying drawings) illustrate a specific number and arrangement of conductive pathways 112 in the interposer 150, these are simply illustrative, and any suitable number and arrangement may be used. The conductive pathways 112 disclosed herein (e.g., including lines 114 and/or vias 116) may be formed of any appropriate conductive material, such as copper, silver, nickel, gold, aluminum, other metals or alloys, or combinations of materials, for example.

The microelectronic assemblies 100 disclosed herein, may be manufactured in any suitable manner. For example, FIGS. 3A-3G are side, cross-sectional views of example stages in the manufacture of a portion of the microelectronic assembly 100 of FIGS. 1 and 2, in accordance with various embodiments. Although the operations discussed with reference to FIGS. 3A-3G may be illustrated with reference to particular embodiments of the microelectronic assemblies 100 disclosed herein, the manufacturing methods discussed with reference to FIGS. 3A-3G may be used to form any suitable microelectronic assemblies 100 operations are illustrated once each and in a particular order in FIGS. 3A-3G, but the operations may be reordered and/or repeated as desired (e.g., with different operations performed in parallel when manufacturing multiple microelectronic assemblies 100 simultaneously). However, any suitable manufacturing processes may be used to manufacture any of the microelectronic assemblies 100 disclosed herein.

FIG. 3A illustrates an interposer 150 including two exposed DB interfaces 180-1 and 180-2. In some embodiments, the interposer 150 may be mounted on a carrier (not shown). The carrier may include any suitable material to provide mechanical support and stability, for example, a glass panel. In some embodiments, the interposer may include a semiconductor wafer (e.g., a silicon wafer).

FIG. 3B illustrates an assembly subsequent to direct bonding microelectronic components 102-1 and 102-2 to the interposer 150 of FIG. 3A. In particular, DB interfaces 180 (not labeled) of the microelectronic components 102 may be brought into contact with the DB interfaces 180 of the interposer 150, and heat and/or pressure may be applied to bond the contacting DB interfaces 180 to form DB regions 130 (with DB regions 130-1 and 130-2 corresponding to the DB interfaces 180-1 and 180-2, respectively).

FIG. 3C illustrates an assembly subsequent to thinning the microelectronic components 102. The microelectronic components 102 may be thinned and planarized using any suitable technique, including, for example, mechanical grinding and chemical and mechanical planarization (CMP). In some embodiments, the microelectronic components 102 are thinned to a thickness between 5 microns and 250 microns. In some embodiments, the microelectronic components 102 are thinned to a thickness of less than 40 microns. In some embodiments, a temporary, removable protective material may be deposited around the microelectronic components 102 prior to thinning to aid with uniformity of the thinning process. In some embodiments, the thinning process may include a dry plasma etch (e.g., SF6) or a wet etch (e.g., using a potassium hydroxide or a tetramethylammonium hydroxide solution) via a timed etch or with an etch stop layer (e.g., silicon oxide). In some embodiments, the thinning process may include hydrogen implantation and ion-cut approach. In some embodiments, the thinning process may further include creating micro-cracks to minimize metal migration in the silicon (e.g., similar to gettering polish).

FIG. 3D illustrates an assembly subsequent to providing a liner material 132 around the microelectronic components 102 and on the surface of the interposer 150 of the assembly of FIG. 3C. The liner material 132 may be deposited using any suitable technique, including, for example, a CVD, an ALD, or a PECVD process.

FIG. 3E illustrates an assembly subsequent to providing an inter-component fill material 126 on the liner material 132. The inter-component fill material 126 may be deposited using any suitable technique, including, for example, a PECVD process or a spin coat and subsequent thermal anneal process. In some embodiments, the inter-component fill material 126 may extend above and remain above the microelectronic components 102, while in other embodiments, the inter-component fill material 126 may be polished back to expose the liner material 132 on the top surfaces of the microelectronic components 102, as shown. In some embodiments, the inter-component fill material 126 may be planarized using CMP and subsequent semiconductor processing may be performed, for example, damascene processing or semi-additive processing, as described below with reference to FIG. 5.

FIG. 3F illustrates an assembly subsequent to coupling the third microelectronic component 102-3 on the inter-component fill material 126 and the first and second microelectronic components 102-1, 102-2. The third microelectronic component 102-3 may be coupled to the assembly via fusion bonding or direct bonding as described below with reference to FIG. 4. The third microelectronic component 102-3 may be referred to as a "handle die." The assembly of FIG. 3F may itself be a microelectronic assembly 100, as shown. Further manufacturing operations may be performed on the microelectronic assembly 100 of FIG. 3F to form other microelectronic assemblies 100; for example, as shown in FIG. 3G. The assembly of FIG. 3F may mechanically function similar to a monolithic wafer.

FIG. 3G illustrates an assembly subsequent to providing solder 120 on the conductive contacts 118, using the solder 120 to couple the microelectronic assembly 100 of FIG. 3F to a support component 182 and providing an underfill material 138 around the solder 120 and extending to the third microelectronic component 102-3, forming the microelectronic assembly 100 of FIG. 1. When a carrier is used, the carrier is removed prior to providing solder 120 on the conductive contacts 118.

FIGS. 4A-4D are side, cross-sectional magnified views of the dotted-line portion of FIG. 3G illustrating example bonding interfaces, in accordance with various embodiments. FIG. 4A illustrates a portion of an interface between first and second microelectronic components 102-1, 102-2 and a third microelectronic component 102-3 having a single material-type interface. As shown in FIG. 4A, the inter-component fill material 126 is around and covering the top surfaces of the first and second microelectronic components 102-1, 102-2, such that the third microelectronic component 102-3 interfaces only with the inter-component fill material 126 to create a single fusion bond interface.

FIG. 4B illustrates a portion of an interface between first and second microelectronic components 102-1, 102-2 and a third microelectronic component 102-3 having a mixed material-type interface. As shown in FIG. 4B, the inter-component fill material 126 is around the first and second microelectronic components 102-1, 102-2 (e.g., fills the space between but does not cover the top surface of the first and second microelectronic components 102-1, 102-2) and the liner material 132 covers the top surfaces of the first and second microelectronic components 102-1, 102-2, such that the third microelectronic component 102-3 interfaces with the inter-component fill material 126 and the liner material 132 to create a mixed fusion bond interface.

FIG. 4C illustrates a portion of an interface between first and second microelectronic components 102-1, 102-2 and a third microelectronic component 102-3 having another single material-type interface. As shown in FIG. 4C, the inter-component fill material 126 is around the first and second microelectronic components 102-1, 102-2 (e.g., fills the space between but does not cover the top surface of the first and second microelectronic components 102-1, 102-2) and a liner material 132 (e.g., a second liner material 132-2) covers the top surfaces of the first and second microelectronic components 102-1, 102-2 as well as the inter-component fill material 126, such that the third microelectronic component 102-3 interfaces only with the second liner material 132-2 to create a single fusion bond interface. In such an interface, a first liner material 132-1 is deposited, the inter-component fill material 126 is deposited, and then a second liner material 132-2 is deposited. In some embodiments, the first and the second liner materials 132-1, 132-2 are the same material. In some embodiments, the first liner material 132-1 is different from the second liner material 132-2.

FIG. 4D illustrates a portion of an interface between first and second microelectronic components 102-1, 102-2 and a third microelectronic component 102-3 having yet another single material-type interface. As shown in FIG. 4D, a material layer 134 is deposited on the inter-component fill material 126 around the first and second microelectronic components 102-1, 102-2 and on the liner material 132 covering the top surfaces of the first and second microelectronic components 102-1, 102-2, such that the third microelectronic component 102-3 interfaces only with the material layer 134 to create a single fusion bond interface. In some embodiments, the material layer 134 may include silicon, carbon, and nitrogen (e.g., in the form of silicon carbon nitride), silicon and nitrogen (e.g., in the form of silicon nitride), silicon, oxygen, and nitrogen (e.g., in the form of silicon oxynitride), silicon and carbon (e.g., in the form of silicon carbide), silicon, oxygen, carbon, and hydrogen (e.g., in the form of tetraethyl orthosilicate (TEOS)), among others.

A microelectronic assembly 100 may include multiple "tiers" of microelectronic components 102 coupled by at least one direct bonding region. For example, FIG. 5 illustrates a microelectronic assembly 100 in which microelectronic components 102-1, 102-2 include conductive contacts (not labeled) on top and bottom surfaces, where conductive contacts on the bottom surface are directly bonded to the interposer 150 and conductive contacts on the top surface are directly bonded to the microelectronic component 102-3. In embodiments where the microelectronic components 102-1, 102-2 are directly bonded with the interposer 150 on a bottom surface and directly bonded with the microelectronic component 102-3 on a top surface, the microelectronic assembly 100 of FIG. 5 may be described as having two tiers of direct bonded microelectronic components 102. In embodiments where the interposer 150 is an active interposer (e.g., an active wafer or an active die), the microelectronic assembly 100 of FIG. 5 may be described as a "three-layer active die composite" and the top die (e.g., microelectronic component 102-3) may be powered and may be functional. In such embodiments, the interposer 150 may be referred to as the first or bottom tier, the first and second microelectronic components 102-1, 102-2 may be referred to as the second or intermediate tier, and the third microelectronic component 102-3 may be referred to as the top or third tier. For example, the third tier may include a higher power central processing unit (CPU) or graphics processing unit (GPU) (e.g., active dies including processing circuitry), the second tier may include memory dies (e.g., active dies including memory circuitry), and the first tier may include power delivery circuitry and functions to power the second and third tier components. In another example, the third tier die may include an active thermal management die that has thermoelectric Peltier cooling circuits that manage heat flow and throttling to maximize the performance of the three-layer active die composite. More generally, any microelectronic component 102 disclosed herein may include one or more dies and may have different types of pass-through conductive interconnects, such as copper pillars and TSVs (e.g., through-silicon vias).

In some embodiments, the microelectronic components 102-1 and 102-2 may further include conductive structures 194 that extend between their top and bottom surfaces, providing conductive pathways for power, ground, and/or signals to the microelectronic component 102-3 in the third tier. In some embodiments, such a conductive structure 194 may include one or more TSVs, including a conductive material via, such as a metal via, isolated from the surrounding silicon or other semiconductor material by a barrier oxide), such as through-silicon vias when the microelectronic components 102-1 and 102-2 include silicon substrates or through-glass vias when the microelectronic components 102-1 and 102-2 include glass substrates. In some embodiments, the microelectronic components 102-1 and 102-2 may be passive (e.g., including no transistors) or active (e.g., including transistors in the form of memory circuitry and/or power delivery circuitry).

As shown in FIG. 5, the microelectronic assembly 100 may further include conductive structures 193 that extend between the second surface 151-2 of the interposer 150 and the bottom surface of the third microelectronic component 102-3 (e.g., through the liner material 132 and the inter-component fill material 126), providing conductive pathways for power, ground, and/or signals directly to the third microelectronic component 102-3 in the third tier.

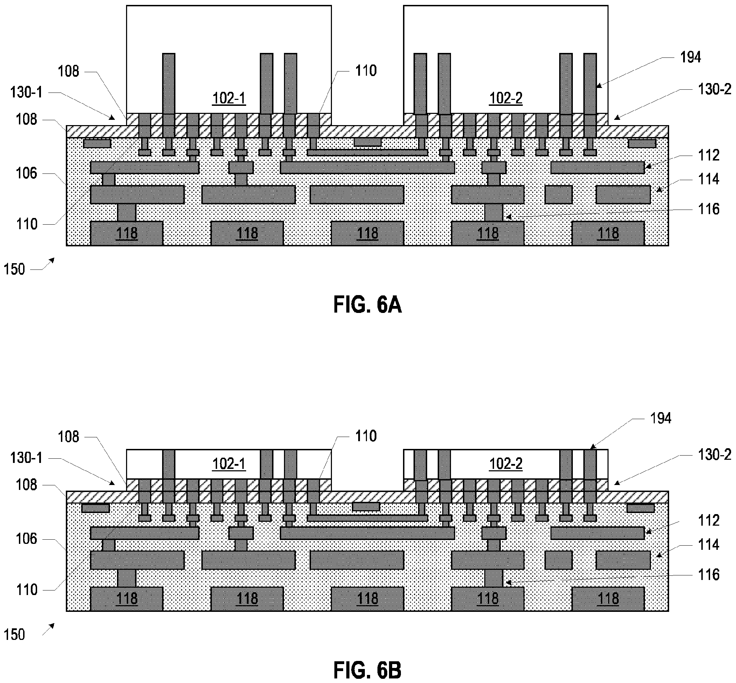

FIG. 6A illustrates an assembly subsequent to direct bonding microelectronic components 102-1, 102-2 having conductive structures 194 to an interposer 150. In particular, DB interfaces 180 (not labeled) of the microelectronic components 102 may be brought into contact with the DB interfaces 180 of the interposer 150, and heat and/or pressure may be applied to bond the contacting DB interfaces 180 to form DB regions 130 (with DB regions 130-1 and 130-2 corresponding to the DB interfaces 180-1 and 180-2, respectively).

FIG. 6B illustrates an assembly subsequent to thinning the microelectronic components 102 and exposing conductive structures 194 on the top surfaces of the microelectronic components 102. The microelectronic components 102 may be thinned and planarized using any suitable technique, including, for example, the techniques described above with reference to FIG. 3C.

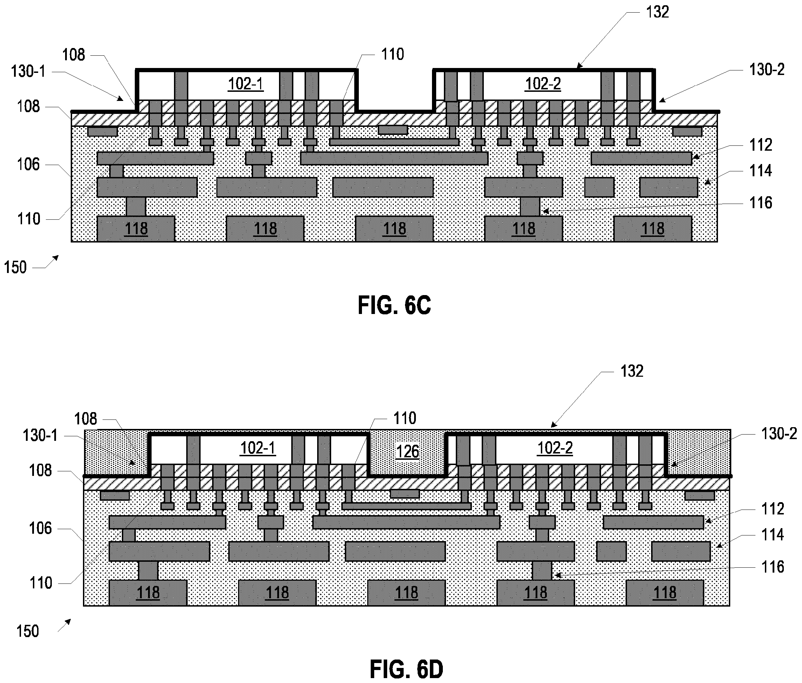

FIG. 6C illustrates an assembly subsequent to providing a liner material 132 around the microelectronic components 102 and on the surface of the interposer 150 of the assembly of FIG. 6B. The liner material 132 may be deposited using any suitable technique, including, for example, as described.

FIG. 6D illustrates an assembly subsequent to providing an inter-component fill material 126 on the liner material 132. The inter-component fill material 126 may be deposited using any suitable technique, including, for example, as described above with reference to FIG. 3E. The inter-component fill material 126 may be polished back or etched to expose the top surfaces of the microelectronic components 102. In some embodiments, the liner material 132 is removed as well, for example, when the liner material 132 includes conductive properties. In some embodiments, the liner material 132 is not removed, for example, when the liner material 132 is insulating or helps prevent the diffusion of copper or other metals. The inter-component fill material 126 may be planarized using CMP and subsequent semiconductor processing may be performed.

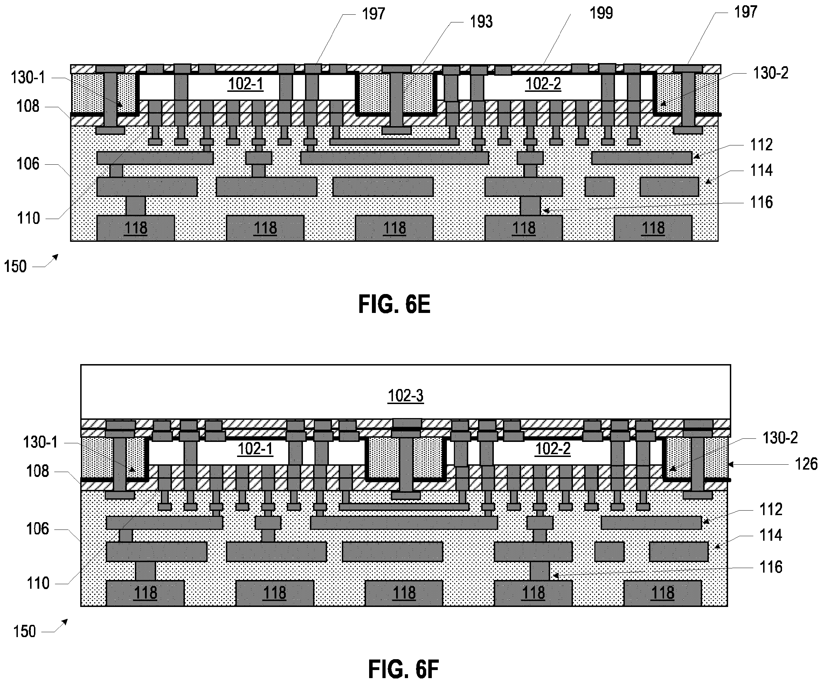

FIG. 6E illustrates an assembly subsequent to forming conductive structures 193 through the inter-component fill material 126 and to forming conductive structures 197 and depositing a dielectric material 199 on the top surfaces of the inter-component fill material 126 and the microelectronic components 102-1, 102-2 using any suitable technique, such as damascene processing.

FIG. 6F illustrates an assembly subsequent to direct bonding the third microelectronic component 102-3 to the top surface of the assembly of FIG. 6E. The assembly of FIG. 6F may itself be a microelectronic assembly 100, as shown. Further manufacturing operations may be performed on the microelectronic assembly 100 of FIG. 6F to form other microelectronic assemblies 100; for example, the assembly of FIG. 6F may be further processed to form the microelectronic assembly of FIG. 5 by providing solder 120 on the conductive contacts 118, using the solder 120 to couple the microelectronic assembly 100 of FIG. 6F to a support component 182, and providing an underfill material 138 around the solder 120 and extending to the third microelectronic component 102-3.

FIG. 7 is a side, cross-sectional view of a microelectronic assembly 100, in accordance with various embodiments. The microelectronic assembly 100 may include an interposer 150, a first microelectronic component 102-1, a second microelectronic component 102-2, a liner material 132, a thermally conductive inter-component fill material 127 selected at least in part for its thermal properties to facilitate heat transfer, and a thermally conductive bulk material 103 selected at least in part for its thermal properties to facilitate heat transfer. In some embodiments, the thermally conductive inter-component fill material 127 may include thermally conductive metal, ceramic, or composite particles or materials including copper, aluminum, silver, diamond, graphene, silicon and carbon (e.g., in the form of silicon carbide), boron and nitrogen (e.g., in the form of boron nitride), or aluminum and nitrogen (e.g., in the form of aluminum nitride), and combinations thereof. The thermally conductive inter-component fill material 127 may provide a path for heat generated by the first and/or second microelectronic components 102-1, 102-2 to be spread and/or dissipated. The thermally conductive inter-component fill material 127 may further include a solvent or a polymer to aid with the dispensability of the material, which may or may not dissipate during processing (e.g., after curing or sintering of the inter-component fill material). The thermally conductive inter-component fill material 127 may be deposited using any suitable technique, for example, stencil/screen printing, additive manufacturing, electrolytic plating, electroless plating, or as described above with reference to FIG. 3E. The thermally conductive inter-component fill material 127 may have a thickness between 10 microns and 250 microns. The thermally conductive inter-component fill material 127 may include a single layer or may include multiple layers. The deposition process may be tuned to optimize mechanical and electrical properties (e.g., porosity and shrinkage) and prevent voids of the thermally conductive inter-component fill material 127. In some embodiments, a thickness of the first and second microelectronic components 102-1, 102-2 may be optimized to reduce the aspect ratio of the inter-component spaces, which may aid with depositing the thermally conductive inter-component fill material 127 without voids. In some embodiments, the thermally conductive inter-component fill material 127 may extend upto and may laterally surround the microelectronic components 102, and in some embodiments (not shown), the thermally conductive inter-component fill material 127 may cover the top surfaces of the microelectronic components 102. Any of the thermally conductive inter-component fill materials 127 referred to herein may include one or more different materials with different material compositions.

The microelectronic assembly 100 of FIG. 7 may also include a liner material 132 selected at least in part for its thermal properties to facilitate heat transfer. The liner material 132 may be disposed on the DB dielectric 108 of the interposer 150 and on and around the first and second microelectronic components 102-1, 102-2. The liner material 132 may serve as a diffusion barrier for the second surface 151-2 of the interposer 150 and all facets (e.g., side surfaces and top surfaces) of the microelectronic components 102-1, 102-2 to limit diffusion of metal species (e.g., the copper diffusion that may occur when the inter-component fill material 127 includes copper) and/or as an adhesion promoter (e.g., to improve the strength of the mechanical interface between the DB dielectric 108 and the thermally conductive inter-component fill material 127, between the top surfaces and side surfaces of the first and second microelectronic components 102-1, 102-2 and the thermally conductive inter-component fill material 127, and/or between the top surfaces of the first and second microelectronic components 102-1, 102-2 and the thermally conductive bulk material 103). In some embodiments, the liner material 132 may include conductive materials, such as titanium, tantalum, vanadium, nickel, ruthenium, cobalt, and/or iridium. Other examples of thermally conductive materials that may be used in the liner material include, but are not limited to, titanium and nitrogen (e.g., in the form of titanium nitride), tantalum and nitrogen (e.g., in the form of tantalum nitride), vanadium and nickel (e.g., in the form of nickel vanadium), or iridium and oxygen (e.g., in the form of iridium oxide), and combinations thereof. In some embodiments, the liner material 132 may include non-conductive materials, such as silicon, carbon, and nitrogen (e.g., in the form of silicon carbon nitride), silicon and nitrogen (e.g., in the form of silicon nitride), silicon and carbon (e.g., in the form of silicon carbide), or titanium and oxygen (e.g., in the form of titanium oxide), and combinations thereof. The liner material 132 may be deposited using any suitable technique, for example, CVD, ALD, or PECVD. During deposition, the temperature, pressure, and power of the process may be adjusted to tune the stress of the film and subsequent stress on the interposer 150 and the first and second microelectronic components 102-1, 102-2. The liner material 132 may have a thickness between 10 nanometers and 2000 nanometers. In some embodiments, the thickness of the liner material 132 may vary (e.g., the liner material 132 may be thicker on the top surfaces of the interposer 150 and the microelectronic components 102 and thinner on the sidewalls of the microelectronic components 102). The microelectronic assembly 100 of FIG. 7 may be manufactured using any suitable manufacturing processes, including the processes described in FIGS. 3A-3G.

The thermally conductive bulk material 103 may include a conductive metal such as copper, aluminum, or silver or a highly conductive non-metal, such as silicon and/or carbon (e.g. silicon, silicon carbide, or diamond). In some embodiments, the thermally conductive bulk material 103 may be in the form of a paste, that is additively manufactured by dispensing on the top surface of the inter-component fill material and the first and second microelectronic components 102-1, 102-2, and then thermally processing. In some embodiments, the thermally conductive bulk material 103 may be composed of thermally conductive metal or nonmetal particles (e.g., from the material examples mentioned above) that are additively manufactured by coldspraying on the top surface of the inter-component fill material and the first and second microelectronic components 102-1, 102-2. In some embodiments, the thermally conductive bulk material 103 may be in the form of a wafer or die (e.g., made of silicon or silicon and carbon) that is bonded on the top surface of the inter-component fill material and the first and second microelectronic components 102-1, 102-2 using die-to-wafer or wafer-to-wafer bonding. A thickness of the thermally conductive bulk material 103 may be between 10 microns and 650 microns.

The microelectronic components 102 and microelectronic assemblies 100 disclosed herein may be included in any suitable electronic component. FIGS. 8-11 illustrate various examples of apparatuses that may include, or be included in, as suitable, any of the microelectronic components 102 and microelectronic assemblies 100 disclosed herein.

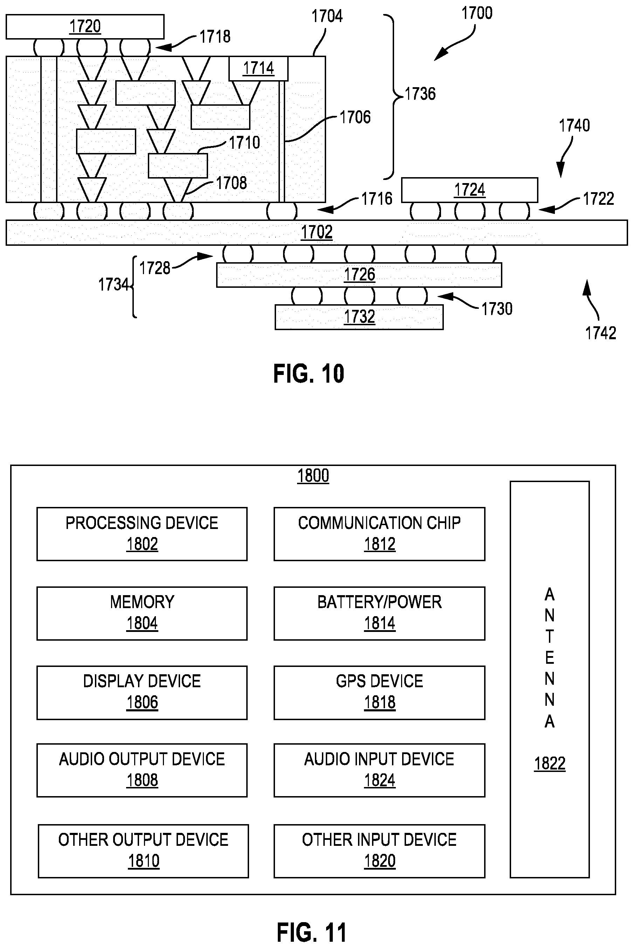

FIG. 8 is a top view of a wafer 1500 and dies 1502 that may be included in any of the microelectronic components 102 disclosed herein. For example, a die 1502 may serve as a microelectronic component 102, or may be included in a microelectronic component 102. The wafer 1500 may be composed of semiconductor material and may include one or more dies 1502 having IC structures formed on a surface of the wafer 1500. Each of the dies 1502 may be a repeating unit of a semiconductor product that includes any suitable IC. After the fabrication of the semiconductor product is complete, the wafer 1500 may undergo a singulation process in which the dies 1502 are separated from one another to provide discrete "chips" of the semiconductor product. The die 1502 may include one or more transistors (e.g., some of the transistors 1640 of FIG. 9, discussed below) and/or supporting circuitry to route electrical signals to the transistors, as well as any other IC components. In some embodiments, the wafer 1500 or the die 1502 may include a memory device (e.g., a random access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Multiple ones of these devices may be combined on a single die 1502. For example, a memory array formed by multiple memory devices may be formed on a same die 1502 as a processing device (e.g., the processing device 1802 of FIG. 11) or other logic that is configured to store information in the memory devices or execute instructions stored in the memory array.

FIG. 9 is a side, cross-sectional view of an IC device 1600 that may be included in any of the microelectronic components 102 disclosed herein. For example, an IC device 1600 (e.g., as part of a die 1502, as discussed above with reference to FIG. 8) may serve as a microelectronic component 102, or may be included in a microelectronic component 102. One or more of the IC devices 1600 may be included in one or more dies 1502 (FIG. 8). The IC device 1600 may be formed on a substrate 1602 (e.g., the wafer 1500 of FIG. 8) and may be included in a die (e.g., the die 1502 of FIG. 8). The substrate 1602 may be a semiconductor substrate composed of semiconductor material systems including, for example, n-type or p-type materials systems (or a combination of both). The substrate 1602 may include, for example, a crystalline substrate formed using a bulk silicon or a silicon-on-insulator (SOI) substructure. In some embodiments, the substrate 1602 may be formed using alternative materials, which may or may not be combined with silicon, that include but are not limited to germanium, indium antimonide, lead telluride, indium arsenide, indium phosphide, gallium arsenide, or gallium antimonide. Further materials classified as group II-VI, III-V, or IV may also be used to form the substrate 1602. Although a few examples of materials from which the substrate 1602 may be formed are described here, any material that may serve as a foundation for an IC device 1600 may be used. The substrate 1602 may be part of a singulated die (e.g., the dies 1502 of FIG. 8) or a wafer (e.g., the wafer 1500 of FIG. 8).

The IC device 1600 may include one or more device layers 1604 disposed on the substrate 1602. The device layer 1604 may include features of one or more transistors 1640 (e.g., metal oxide semiconductor field-effect transistors (MOSFETs)) formed on the substrate 1602. The device layer 1604 may include, for example, one or more source and/or drain (S/D) regions 1620, a gate 1622 to control current flow in the transistors 1640 between the S/D regions 1620, and one or more S/D contacts 1624 to route electrical signals to/from the S/D regions 1620. The transistors 1640 may include additional features not depicted for the sake of clarity, such as device isolation regions, gate contacts, and the like. The transistors 1640 are not limited to the type and configuration depicted in FIG. 9 and may include a wide variety of other types and configurations such as, for example, planar transistors, non-planar transistors, or a combination of both. Planar transistors may include bipolar junction transistors (BJT), heterojunction bipolar transistors (HBT), or high-electron-mobility transistors (HEMT). Non-planar transistors may include FinFET transistors, such as double-gate transistors or tri-gate transistors, and wrap-around or all-around gate transistors, such as nanoribbon and nanowire transistors.

Each transistor 1640 may include a gate 1622 formed of at least two layers, a gate dielectric and a gate electrode. The gate dielectric may include one layer or a stack of layers. The one or more layers may include silicon oxide, silicon dioxide, silicon carbide, and/or a high-k dielectric material. The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric to improve its quality when a high-k material is used.

The gate electrode may be formed on the gate dielectric and may include at least one p-type work function metal or n-type work function metal, depending on whether the transistor 1640 is to be a p-type metal oxide semiconductor (PMOS) or an n-type metal oxide semiconductor (NMOS) transistor. In some implementations, the gate electrode may consist of a stack of two or more metal layers, where one or more metal layers are work function metal layers and at least one metal layer is a fill metal layer. Further metal layers may be included for other purposes, such as a barrier layer. For a PMOS transistor, metals that may be used for the gate electrode include, but are not limited to, ruthenium, palladium, platinum, cobalt, nickel, conductive metal oxides (e.g., ruthenium oxide), and any of the metals discussed below with reference to an NMOS transistor (e.g., for work function tuning). For an NMOS transistor, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and aluminum carbide), and any of the metals discussed above with reference to a PMOS transistor (e.g., for work function tuning).

In some embodiments, when viewed as a cross-section of the transistor 1640 along the source-channel-drain direction, the gate electrode may consist of a U-shaped structure that includes a bottom portion substantially parallel to the surface of the substrate and two sidewall portions that are substantially perpendicular to the top surface of the substrate. In other embodiments, at least one of the metal layers that form the gate electrode may simply be a planar layer that is substantially parallel to the top surface of the substrate and does not include sidewall portions substantially perpendicular to the top surface of the substrate. In other embodiments, the gate electrode may consist of a combination of U-shaped structures and planar, non-U-shaped structures. For example, the gate electrode may consist of one or more U-shaped metal layers formed atop one or more planar, non-U-shaped layers.

In some embodiments, a pair of sidewall spacers may be formed on opposing sides of the gate stack to bracket the gate stack. The sidewall spacers may be formed from materials such as silicon nitride, silicon oxide, silicon carbide, silicon nitride doped with carbon, and silicon oxynitride. Processes for forming sidewall spacers are well known in the art and generally include deposition and etching process steps. In some embodiments, a plurality of spacer pairs may be used; for instance, two pairs, three pairs, or four pairs of sidewall spacers may be formed on opposing sides of the gate stack.

The S/D regions 1620 may be formed within the substrate 1602 adjacent to the gate 1622 of each transistor 1640. The S/D regions 1620 may be formed using an implantation/diffusion process or an etching/deposition process, for example. In the former process, dopants such as boron, aluminum, antimony, phosphorous, or arsenic may be ion-implanted into the substrate 1602 to form the S/D regions 1620. An annealing process that activates the dopants and causes them to diffuse farther into the substrate 1602 may follow the ion-implantation process. In the latter process, the substrate 1602 may first be etched to form recesses at the locations of the S/D regions 1620. An epitaxial deposition process may then be carried out to fill the recesses with material that is used to fabricate the S/D regions 1620. In some implementations, the S/D regions 1620 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 1620 may be formed using one or more alternate semiconductor materials such as germanium or a group III-V material or alloy. In further embodiments, one or more layers of metal and/or metal alloys may be used to form the S/D regions 1620.

Electrical signals, such as power and/or input/output (I/O) signals, may be routed to and/or from the devices (e.g., the transistors 1640) of the device layer 1604 through one or more interconnect layers disposed on the device layer 1604 (illustrated in FIG. 9 as interconnect layers 1606-1610). For example, electrically conductive features of the device layer 1604 (e.g., the gate 1622 and the S/D contacts 1624) may be electrically coupled with the interconnect structures 1628 of the interconnect layers 1606-1610. The one or more interconnect layers 1606-1610 may form a metallization stack (also referred to as an "ILD stack") 1619 of the IC device 1600.

The interconnect structures 1628 may be arranged within the interconnect layers 1606-1610 to route electrical signals according to a wide variety of designs (in particular, the arrangement is not limited to the particular configuration of interconnect structures 1628 depicted in FIG. 9). Although a particular number of interconnect layers 1606-1610 is depicted in FIG. 9, embodiments of the present disclosure include IC devices having more or fewer interconnect layers than depicted.

In some embodiments, the interconnect structures 1628 may include lines 1628a and/or vias 1628b filled with an electrically conductive material such as a metal. The lines 1628a may be arranged to route electrical signals in a direction of a plane that is substantially parallel with a surface of the substrate 1602 upon which the device layer 1604 is formed. For example, the lines 1628a may route electrical signals in a direction in and out of the page from the perspective of FIG. 9. The vias 1628b may be arranged to route electrical signals in a direction of a plane that is substantially perpendicular to the surface of the substrate 1602 upon which the device layer 1604 is formed. In some embodiments, the vias 1628b may electrically couple lines 1628a of different interconnect layers 1606-1610 together.

The interconnect layers 1606-1610 may include a dielectric material 1626 disposed between the interconnect structures 1628, as shown in FIG. 9. In some embodiments, the dielectric material 1626 disposed between the interconnect structures 1628 in different ones of the interconnect layers 1606-1610 may have different compositions; in other embodiments, the composition of the dielectric material 1626 between different interconnect layers 1606-1610 may be the same.

A first interconnect layer 1606 may be formed above the device layer 1604. In some embodiments, the first interconnect layer 1606 may include lines 1628a and/or vias 1628b, as shown. The lines 1628a of the first interconnect layer 1606 may be coupled with contacts (e.g., the S/D contacts 1624) of the device layer 1604.

A second interconnect layer 1608 may be formed above the first interconnect layer 1606. In some embodiments, the second interconnect layer 1608 may include vias 1628b to couple the lines 1628a of the second interconnect layer 1608 with the lines 1628a of the first interconnect layer 1606. Although the lines 1628a and the vias 1628b are structurally delineated with a line within each interconnect layer (e.g., within the second interconnect layer 1608) for the sake of clarity, the lines 1628a and the vias 1628b may be structurally and/or materially contiguous (e.g., simultaneously filled during a dual-damascene process) in some embodiments.

A third interconnect layer 1610 (and additional interconnect layers, as desired) may be formed in succession on the second interconnect layer 1608 according to similar techniques and configurations described in connection with the second interconnect layer 1608 or the first interconnect layer 1606. In some embodiments, the interconnect layers that are "higher up" in the metallization stack 1619 in the IC device 1600 (i.e., farther away from the device layer 1604) may be thicker.

The IC device 1600 may include a solder resist material 1634 (e.g., polyimide or similar material) and one or more conductive contacts 1636 formed on the interconnect layers 1606-1610. In FIG. 9, the conductive contacts 1636 are illustrated as taking the form of bond pads. The conductive contacts 1636 may be electrically coupled with the interconnect structures 1628 and configured to route the electrical signals of the transistor(s) 1640 to other external devices. For example, solder bonds may be formed on the one or more conductive contacts 1636 to mechanically and/or electrically couple a chip including the IC device 1600 with another component (e.g., a circuit board). The IC device 1600 may include additional or alternate structures to route the electrical signals from the interconnect layers 1606-1610; for example, the conductive contacts 1636 may include other analogous features (e.g., posts) that route the electrical signals to external components.

FIG. 10 is a side, cross-sectional view of an IC device assembly 1700 that may include any of the microelectronic components 102 and/or microelectronic assemblies 100 disclosed herein. The IC device assembly 1700 includes a number of components disposed on a circuit board 1702 (which may be, e.g., a motherboard). The IC device assembly 1700 includes components disposed on a first face 1740 of the circuit board 1702 and an opposing second face 1742 of the circuit board 1702; generally, components may be disposed on one or both faces 1740 and 1742. Any of the IC packages discussed below with reference to the IC device assembly 1700 may include any of the embodiments of the microelectronic assemblies 100 disclosed herein (e.g., may include multiple microelectronic components 102 coupled together by direct bonding).

In some embodiments, the circuit board 1702 may be a PCB including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 1702. In other embodiments, the circuit board 1702 may be a non-PCB substrate.

The IC device assembly 1700 illustrated in FIG. 10 includes a package-on-interposer structure 1736 coupled to the first face 1740 of the circuit board 1702 by coupling components 1716. The coupling components 1716 may electrically and mechanically couple the package-on-interposer structure 1736 to the circuit board 1702, and may include solder balls (as shown in FIG. 10), male and female portions of a socket, an adhesive, an underfill material, and/or any other suitable electrical and/or mechanical coupling structure.

The package-on-interposer structure 1736 may include an IC package 1720 coupled to a package interposer 1704 by coupling components 1718. The coupling components 1718 may take any suitable form for the application, such as the forms discussed above with reference to the coupling components 1716. Although a single IC package 1720 is shown in FIG. 10, multiple IC packages may be coupled to the package interposer 1704; indeed, additional interposers may be coupled to the package interposer 1704. The package interposer 1704 may provide an intervening substrate used to bridge the circuit board 1702 and the IC package 1720. The IC package 1720 may be or include, for example, a die (the die 1502 of FIG. 8), an IC device (e.g., the IC device 1600 of FIG. 9), or any other suitable component. Generally, the package interposer 1704 may spread a connection to a wider pitch or reroute a connection to a different connection. For example, the package interposer 1704 may couple the IC package 1720 (e.g., a die) to a set of BGA conductive contacts of the coupling components 1716 for coupling to the circuit board 1702. In the embodiment illustrated in FIG. 10, the IC package 1720 and the circuit board 1702 are attached to opposing sides of the package interposer 1704; in other embodiments, the IC package 1720 and the circuit board 1702 may be attached to a same side of the package interposer 1704. In some embodiments, three or more components may be interconnected by way of the package interposer 1704.

In some embodiments, the package interposer 1704 may be formed as a PCB, including multiple metal layers separated from one another by layers of dielectric material and interconnected by electrically conductive vias. In some embodiments, the package interposer 1704 may be formed of an epoxy resin, a fiberglass-reinforced epoxy resin, an epoxy resin with inorganic fillers, a ceramic material, or a polymer material such as polyimide. In some embodiments, the package interposer 1704 may be formed of alternate rigid or flexible materials that may include the same materials described above for use in a semiconductor substrate, such as silicon, germanium, and other group III-V and group IV materials. The package interposer 1704 may include metal lines 1710 and vias 1708, including but not limited to TSVs 1706. The package interposer 1704 may further include embedded devices 1714, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the package interposer 1704. The package-on-interposer structure 1736 may take the form of any of the package-on-interposer structures known in the art.

The IC device assembly 1700 may include an IC package 1724 coupled to the first face 1740 of the circuit board 1702 by coupling components 1722. The coupling components 1722 may take the form of any of the embodiments discussed above with reference to the coupling components 1716, and the IC package 1724 may take the form of any of the embodiments discussed above with reference to the IC package 1720.

The IC device assembly 1700 illustrated in FIG. 10 includes a package-on-package structure 1734 coupled to the second face 1742 of the circuit board 1702 by coupling components 1728. The package-on-package structure 1734 may include an IC package 1726 and an IC package 1732 coupled together by coupling components 1730 such that the IC package 1726 is disposed between the circuit board 1702 and the IC package 1732. The coupling components 1728 and 1730 may take the form of any of the embodiments of the coupling components 1716 discussed above, and the IC packages 1726 and 1732 may take the form of any of the embodiments of the IC package 1720 discussed above. The package-on-package structure 1734 may be configured in accordance with any of the package-on-package structures known in the art.

FIG. 11 is a block diagram of an example electrical device 1800 that may include any of the microelectronic components 102 and/or microelectronic assemblies 100 disclosed herein. For example, any suitable ones of the components of the electrical device 1800 may include one or more of the IC device assemblies 1700, IC devices 1600, or dies 1502 disclosed herein. A number of components are illustrated in FIG. 11 as included in the electrical device 1800, but any one or more of these components may be omitted or duplicated, as suitable for the application. In some embodiments, some or all of the components included in the electrical device 1800 may be attached to one or more motherboards. In some embodiments, some or all of these components are fabricated onto a single system-on-a-chip (SoC) die.

Additionally, in various embodiments, the electrical device 1800 may not include one or more of the components illustrated in FIG. 11, but the electrical device 1800 may include interface circuitry for coupling to the one or more components. For example, the electrical device 1800 may not include a display device 1806, but may include display device interface circuitry (e.g., a connector and driver circuitry) to which a display device 1806 may be coupled. In another set of examples, the electrical device 1800 may not include an audio input device 1824 or an audio output device 1808, but may include audio input or output device interface circuitry (e.g., connectors and supporting circuitry) to which an audio input device 1824 or audio output device 1808 may be coupled.

The electrical device 1800 may include a processing device 1802 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 1802 may include one or more digital signal processors (DSPs), application-specific integrated circuits (ASICs), CPUs, GPUs, cryptoprocessors (specialized processors that execute cryptographic algorithms within hardware), server processors, or any other suitable processing devices. The electrical device 1800 may include a memory 1804, which may itself include one or more memory devices such as volatile memory (e.g., dynamic random access memory (DRAM)), nonvolatile memory (e.g., read-only memory (ROM)), flash memory, solid state memory, and/or a hard drive. In some embodiments, the memory 1804 may include memory that shares a die with the processing device 1802. This memory may be used as cache memory and may include embedded dynamic random access memory (eDRAM) or spin transfer torque magnetic random access memory (STT-MRAM).

In some embodiments, the electrical device 1800 may include a communication chip 1812 (e.g., one or more communication chips). For example, the communication chip 1812 may be configured for managing wireless communications for the transfer of data to and from the electrical device 1800. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 1812 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 1812 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 1812 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 1812 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 1812 may operate in accordance with other wireless protocols in other embodiments. The electrical device 1800 may include an antenna 1822 to facilitate wireless communications and/or to receive other wireless communications (such as AM or FM radio transmissions).

In some embodiments, the communication chip 1812 may manage wired communications, such as electrical, optical, or any other suitable communication protocols (e.g., the Ethernet). As noted above, the communication chip 1812 may include multiple communication chips. For instance, a first communication chip 1812 may be dedicated to shorter-range wireless communications such as Wi-Fi or Bluetooth, and a second communication chip 1812 may be dedicated to longer-range wireless communications such as global positioning system (GPS), EDGE, GPRS, CDMA, WiMAX, LTE, EV-DO, or others. In some embodiments, a first communication chip 1812 may be dedicated to wireless communications, and a second communication chip 1812 may be dedicated to wired communications.

The electrical device 1800 may include battery/power circuitry 1814. The battery/power circuitry 1814 may include one or more energy storage devices (e.g., batteries or capacitors) and/or circuitry for coupling components of the electrical device 1800 to an energy source separate from the electrical device 1800 (e.g., AC line power).

The electrical device 1800 may include a display device 1806 (or corresponding interface circuitry, as discussed above). The display device 1806 may include any visual indicators, such as a heads-up display, a computer monitor, a projector, a touchscreen display, a liquid crystal display (LCD), a light-emitting diode display, or a flat panel display.

The electrical device 1800 may include an audio output device 1808 (or corresponding interface circuitry, as discussed above). The audio output device 1808 may include any device that generates an audible indicator, such as speakers, headsets, or earbuds.

The electrical device 1800 may include an audio input device 1824 (or corresponding interface circuitry, as discussed above). The audio input device 1824 may include any device that generates a signal representative of a sound, such as microphones, microphone arrays, or digital instruments (e.g., instruments having a musical instrument digital interface (MIDI) output).

The electrical device 1800 may include a GPS device 1818 (or corresponding interface circuitry, as discussed above). The GPS device 1818 may be in communication with a satellite-based system and may receive a location of the electrical device 1800, as known in the art.

The electrical device 1800 may include an other output device 1810 (or corresponding interface circuitry, as discussed above). Examples of the other output device 1810 may include an audio codec, a video codec, a printer, a wired or wireless transmitter for providing information to other devices, or an additional storage device.

The electrical device 1800 may include an other input device 1820 (or corresponding interface circuitry, as discussed above). Examples of the other input device 1820 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The electrical device 1800 may have any desired form factor, such as a handheld or mobile electrical device (e.g., a cell phone, a smart phone, a mobile internet device, a music player, a tablet computer, a laptop computer, a netbook computer, an ultrabook computer, a personal digital assistant (PDA), an ultra mobile personal computer, etc.), a desktop electrical device, a server device or other networked computing component, a printer, a scanner, a monitor, a set-top box, an entertainment control unit, a vehicle control unit, a digital camera, a digital video recorder, or a wearable electrical device. In some embodiments, the electrical device 1800 may be any other electronic device that processes data.

The following paragraphs provide various examples of the embodiments disclosed herein.
Example 1A is a microelectronic assembly, including an interposer having a first surface and an opposing second surface; a first microelectronic component coupled to the second surface of the interposer by a first direct bonding region; a second microelectronic component coupled to the second surface of the interposer by a second direct bonding region; a liner material on the second surface of the interposer and around the first and second microelectronic components; and a thermally conductive fill material on the liner material and between the first and second microelectronic components.
Example 2A may include the subject matter of Example 1A, and may further specify that the thermally conductive fill material includes ceramic, copper, aluminum, silver, diamond, graphene, silicon and carbon, boron and nitrogen, or aluminum and nitrogen, and combinations thereof.
Example 3A may include the subject matter of Example 1A, and may further specify that a thickness of the thermally conductive fill material is between 10 microns and 250 microns.
Example 4A may include the subject matter of Example 1A, and may further specify that the liner material includes titanium, tantalum, vanadium, nickel, ruthenium, cobalt, iridium, titanium and nitrogen, tantalum and nitrogen, vanadium and nickel, iridium and oxygen, silicon and carbon and nitrogen, silicon and nitrogen, silicon and carbon, or titanium and oxygen, and combinations thereof.
Example 5A may include the subject matter of Example 1A, and may further specify that a thickness of the liner material is between 10 nanometers and 2000 nanometers.
Example 6A may include the subject matter of Example 1A, and may further specify that a thickness of the first and the second microelectronic components is less than or equal to 40 microns.
Example 7A may include the subject matter of Example 1A, and may further specify that the first and second microelectronic components include first surfaces coupled to the interposer and opposing second surfaces, and may further include a thermally conductive bulk material bonded to the second surfaces of the first and second microelectronic components.
Example 8A may include the subject matter of Example 7A, and may further specify that a thickness of the thermally conductive bulk material is between 10 microns and 650 microns.
Example 9A may include the subject matter of Example 1A,, wherein the thermally conductive bulk material includes copper, aluminum, silver, silicon, silicon and carbon, or diamond, and combinations thereof.
Example 10A may include the subject matter of Example 7A, and may further include a package substrate coupled to the first surface of the interposer; and an underfill material extending between the package substrate and the thermally conductive bulk material.
Example 11A is a microelectronic assembly, including an interposer having a first face and an opposing second face; a first microelectronic component, having a first surface and an opposing second surface, coupled at the first surface to the second face of the interposer by a first direct bonding region; a second microelectronic component, having a first surface and an opposing second surface, coupled at the first surface to the second face of the interposer by a second direct bonding region; a liner material on the second surface of the interposer and around the first and second microelectronic components; a thermally conductive fill material on the liner material and between the first and second microelectronic components; and a thermally conductive bulk material bonded to the second surfaces of the first and second microelectronic components.
Example 12A may include the subject matter of Example 11A, and may further specify that the interposer includes an organic dielectric material.
Example 13A may include the subject matter of Example 11A, and may further specify that the interposer includes an inorganic dielectric material.
Example 14A may include the subject matter of Example 11A, and may further include a package substrate coupled to the first surface of the interposer; and an underfill material extending between the package substrate and the thermally conductive bulk material.
Example 15A may include the subject matter of Example 11A, and may further specify that the first and second microelectronic components include semiconductor dies.
Example 16A is a microelectronic assembly, including an interposer; a first microelectronic component, having a first surface and an opposing second surface, wherein the first surface of the first microelectronic component is coupled to the interposer by a first direct bonding region; a second microelectronic component, having a first surface and an opposing second surface, wherein the first surface of the second microelectronic component is coupled to the interposer by a second direct bonding region; a thermally conductive fill material on the surface of the interposer and between the first and second microelectronic components; and a thermally conductive bulk material bonded to the second surfaces of the first and second microelectronic components.
Example 17A may include the subject matter of Example 16A, and may further specify that the thermally conductive fill material includes ceramic, copper, aluminum, silver, diamond, graphene, silicon and carbon, boron and nitrogen, or aluminum and nitrogen, and combinations thereof.
Example 18A may include the subject matter of Example 16A, and may further specify that the thermally conductive bulk material includes copper, aluminum, silver, silicon, silicon and carbon, or diamond, and combinations thereof.
Example 19A may include the subject matter of Example 16A, and may further include a liner material between the interposer and the thermally conductive fill material and between the first and second microelectronic components and the thermally conductive fill material.
Example 20A may include the subject matter of Example 19A, and may further specify that the liner material includes titanium, tantalum, vanadium, nickel, ruthenium, cobalt, iridium, titanium and nitrogen, tantalum and nitrogen, vanadium and nickel, iridium and oxygen, silicon and carbon and nitrogen, silicon and nitrogen, silicon and carbon, or titanium and oxygen, and combinations thereof.
Example 1B is a microelectronic assembly, including an interposer having a first surface and an opposing second surface; a first microelectronic component coupled to the second surface of the interposer by a first direct bonding region; a second microelectronic component coupled to the second surface of the interposer by a second direct bonding region; a liner material on the second surface of the interposer and around the first and second microelectronic components; and an inorganic dielectric material on the liner material and between the first and second microelectronic components.
Example 2B may include the subject matter of Example 1B, and may further specify that the inorganic dielectric material includes silicon and oxygen, or silicon and nitrogen, or a combination thereof.
Example 3B may include the subject matter of Example 1B, and may further specify that a thickness of the inorganic dielectric material is between 10 microns and 250 microns.
Example 4B may include the subject matter of Example 1B, and may further specify that the liner material includes silicon and carbon and nitrogen, silicon and nitrogen, silicon and oxygen and nitrogen, or silicon and carbon.
Example 5B may include the subject matter of Example 1B, and may further specify that a thickness of the liner material is between 10 nanometers and 2000 nanometers.
Example 6B may include the subject matter of Example 1B, and may further specify that a thickness of the first and the second microelectronic components is less than or equal to 40 microns.
Example 7B may include the subject matter of Example 1B, and may further specify that the first and second microelectronic components include first surfaces coupled to the interposer and opposing second surfaces, and may further include a third microelectronic component coupled to the second surfaces of the first and second microelectronic components.
Example 8B may include the subject matter of Example 7B, and may further specify that the inorganic dielectric material is a first inorganic dielectric material, and may further include a second inorganic dielectric material on the first inorganic dielectric material and on the second surfaces of the first and second microelectronic components, wherein the third microelectronic component is coupled to the second inorganic dielectric material by a fusion bonding region.
Example 9B may include the subject matter of Example 7B, and may further specify that the first and second microelectronic components are single-sided dies, wherein the third microelectronic component is a passive die, and wherein the third microelectronic component is coupled to the second surfaces of the first and second microelectronic components by a fusion bonding region.
Example 10B may include the subject matter of Example 9B, and may further specify that the third microelectronic component further includes thermal dissipative structures.
Example 11B is a microelectronic assembly, including an interposer having a first face and an opposing second face; a first microelectronic component, having a first surface and an opposing second surface, coupled at the first surface to the second face of the interposer by a first direct bonding region; a second microelectronic component, having a first surface and an opposing second surface, coupled at the first surface to the second face of the interposer by a second direct bonding region; a liner material on the second surface of the interposer and around the first and second microelectronic components; an inorganic fill material on the liner material and between the first and second microelectronic components; and a third microelectronic component coupled to the second surfaces of the first and second microelectronic components.
Example 12B may include the subject matter of Example 11B, and may further specify that the first and second microelectronic components are double-sided dies, wherein the third microelectronic component is an active die, and wherein the third microelectronic component is coupled to the second surfaces of the first and second microelectronic components by a third direct bonding region.
Example 13B may include the subject matter of Example 12B, and may further include a through substrate via (TSV) through the inorganic fill material electrically coupling the third microelectronic component and the interposer.
Example 14B may include the subject matter of Example 13B, and may further specify that the interposer includes power delivery circuitry, the first and second microelectronic components include memory circuitry, and the third microelectronic component includes processing circuitry.
Example 15B may include the subject matter of Example 11B, and may further include a package substrate coupled to the first face of the interposer; and an underfill material extending between the package substrate and the third microelectronic component.
Example 16B is a microelectronic assembly, including an interposer; a first microelectronic component, having a first surface and an opposing second surface, wherein the first surface of the first microelectronic component is coupled to the interposer by a first direct bonding region; a second microelectronic component, having a first surface and an opposing second surface, wherein the first surface of the second microelectronic component is coupled to the interposer by a second direct bonding region; a liner material on the surface of the interposer and around the first and second microelectronic components; an inorganic fill material on the liner material and between the first and second microelectronic components; and a third microelectronic component coupled to the second surfaces of the first and second microelectronic components.
Example 17B may include the subject matter of Example 16B, and may further specify that the inorganic dielectric material includes silicon and oxygen, or silicon and nitrogen, or a combination thereof.
Example 18B may include the subject matter of Example 16B, and may further specify that the liner material includes silicon and carbon and nitrogen, silicon and nitrogen, silicon and oxygen and nitrogen, or silicon and carbon, and combination thereof.
Example 19B may include the subject matter of Example 16B, and may further specify that a thickness of the inorganic dielectric material is between 10 microns and 250 microns.
Example 2B0 may include the subject matter of Example 16B, and may further specify that a thickness of the liner material is between 10 nanometers and 2000 nanometers.

## Claims

1. A microelectronic assembly, comprising:
an interposer having a first surface and an opposing second surface;
a first microelectronic component coupled to the second surface of the interposer by a first direct bonding region;
a second microelectronic component coupled to the second surface of the interposer by a second direct bonding region;
a liner material on the second surface of the interposer and around the first and second microelectronic components; and
a thermally conductive fill material on the liner material and between the first and second microelectronic components.

2. The microelectronic assembly of claim 1, wherein the thermally conductive fill material includes ceramic, copper, aluminum, silver, diamond, graphene, silicon and carbon, boron and nitrogen, or aluminum and nitrogen, and combinations thereof.

3. The microelectronic assembly of claim 2, wherein a thickness of the thermally conductive fill material is between 10 microns and 250 microns.

4. The microelectronic assembly of claim 1, wherein the liner material includes titanium, tantalum, vanadium, nickel, ruthenium, cobalt, iridium, titanium and nitrogen, tantalum and nitrogen, vanadium and nickel, iridium and oxygen, silicon and carbon and nitrogen, silicon and nitrogen, silicon and carbon, or titanium and oxygen, and combinations thereof.

5. The microelectronic assembly of claim 4, wherein a thickness of the liner material is between 10 nanometers and 2000 nanometers.

6. The microelectronic assembly of any one of claims 1-5, wherein a thickness of the first and the second microelectronic components is less than or equal to 40 microns.

7. The microelectronic assembly of any one of claims 1-5, wherein the first and second microelectronic components include first surfaces coupled to the interposer and opposing second surfaces, and further comprising:
a thermally conductive bulk material bonded to the second surfaces of the first and second microelectronic components.

8. The microelectronic assembly of claim 7, wherein a thickness of the thermally conductive bulk material is between 10 microns and 650 microns.

9. The microelectronic assembly of claim 7, wherein the thermally conductive bulk material includes copper, aluminum, silver, silicon, silicon and carbon, or diamond, and combinations thereof.

10. The microelectronic assembly of claim 7, further comprising:
a package substrate coupled to the first surface of the interposer; and
an underfill material extending between the package substrate and the thermally conductive bulk material.

11. The microelectronic assembly of any one of claims 1-5, wherein the interposer includes an organic dielectric material.

12. The microelectronic assembly of any one of claims 1-5, wherein the interposer includes an inorganic dielectric material.

13. The microelectronic assembly of any one of claims 1-5, wherein the first and second microelectronic components include semiconductor dies.
